(19) Europäisches Patentamt
European Patent Office
Office européen des brevets

(11) EP 2 842 737 A1

(12) # EUROPEAN PATENT APPLICATION
published in accordance with Art. 153(4) EPC

(43) Date of publication:
**04.03.2015 Bulletin 2015/10**

(21) Application number: **13782541.0**

(22) Date of filing: **24.04.2013**

(51) Int Cl.:
***B32B 9/00*** *(2006.01)* ***B05D 7/04*** *(2006.01)*
***B05D 7/24*** *(2006.01)* ***C08J 7/04*** *(2006.01)*
***H01L 51/50*** *(2006.01)* ***H05B 33/04*** *(2006.01)*

(86) International application number:
**PCT/JP2013/062103**

(87) International publication number:
**WO 2013/161894 (31.10.2013 Gazette 2013/44)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **25.04.2012 JP 2012100245**

(71) Applicant: **Konica Minolta, Inc.**
**Tokyo 100-7015 (JP)**

(72) Inventor: **HONDA, Makoto**
**Tokyo 100-7015 (JP)**

(74) Representative: **Gille Hrabal**
**Brucknerstrasse 20**
**40593 Düsseldorf (DE)**

(54) **GAS BARRIER FILM, SUBSTRATE FOR ELECTRONIC DEVICE, AND ELECTRONIC DEVICE**

(57) The purpose of the present invention is to provide a gas barrier film, which has a gas barrier film, which has a film having optical anisotropy as a base material, extremely excellent gas barrier performance, excellent productivity, and excellent visibility, and which is applicable to an OLED display.

This gas barrier film has a film base material (1) having optical anisotropy, and a gas barrier unit, which is disposed at least on one surface of the film base material (1). The gas barrier unit sequentially includes from the film base material (1) side, a first barrier layer (3) containing inorganic material, and a second barrier layer (4) obtained by modifying a coating film formed by applying polysilazane.

FIG. 1

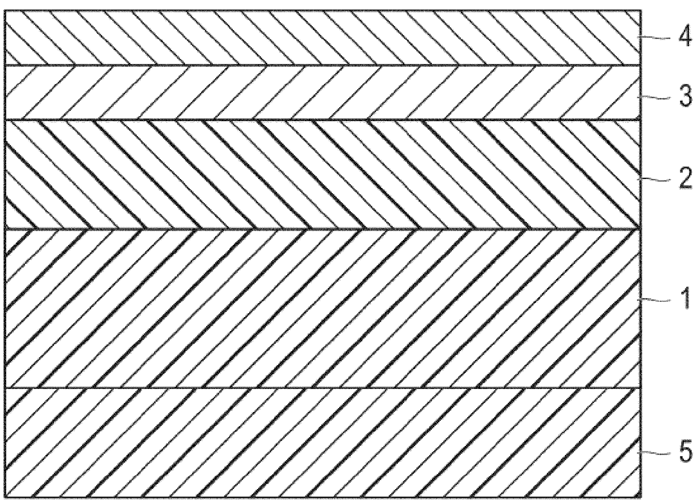


EP 2 842 737 A1

## Description

## TECHNICAL FIELD

The present invention relates to a gas barrier film, a substrate for an electronic device, and an electronic device. More specifically, the present invention relates to a gas barrier film which is mainly used for an electronic device such as an organic electroluminescence (EL) element, a solar cellelement, or a liquid crystal displayelement, a substrate for an electronic device and an electronic device which use the same.

## BACKGROUND ART

Conventionally, a gas barrier film formed by laminating plural layers including a thin film of a metal oxide such as aluminum oxide, magnesium oxide, or silicon oxide on the surface of a plastic substrate or film has been widely used for purposes of packaging articles that need to be shield against various types of gases such as water vapor and oxygen, for example, for applications of packaging for preventing food products, industrial products, and pharmaceutical products from being deteriorated.

In addition to the packaging applications, development into a flexible electronic device such as a solar cell element, an organic electroluminescence (EL) element, or a liquid crystal display element having flexibility is required, and thus various studies are made. However, since those flexible electronic devices are required to have a very high gas barrier property that is at the same level as a glass base material, as the case now stands, a gas barrier film with satisfying performance has not been obtained yet.

As a method for forming such a gas barrier film, there has been known a gas phase method such as a chemical deposition method (plasma CVD method: Chemical Vapor Deposition) in which an organosilicon compound represented by tetraethoxysilane (TEOS) is used and the organosilicon compound is allowed to be grown on a substrate while oxidizing the compound by oxygen plasma under reduced pressure or a physical deposition method (vacuum vapor deposition method or sputtering method) in which metal Si is evaporated to be deposited on a substrate using a semiconductor laser in the presence of oxygen.

Inorganic film formation methods by employing these gas phase methods have been preferably applied to formation of inorganic films including silicon oxide, silicone nitride, silicon oxynitride, or the like. Lots of studies have been made on a composition range of inorganic films in order to obtain favorable gas barrier properties and on a layer configuration including these inorganic films. However, the composition range and the layer configuration by which gas barrier properties become particularly favorable have not been specified.

Further, it is very difficult to form a film without any defect by the gas phase methods as described above. For example, a measure in which occurrence of defects is suppressed by extremely decreasing a film formation rate, or the like is necessary. Accordingly, as the case now stands, gas barrier properties required for flexible electronic devices have not been attained in an industrial level required for productivity. Although a study has been made on that a film thickness of the inorganic film formed by the gas phase method is simply increased or plural inorganic films are laminated, since a defect continuously grows and the number of cracks is contrarily increased, any film having an improved gas barrier property has not been obtained yet.

Meanwhile, as one of methods for forming a gas barrier layer without employing the gas phase film formation method as described above, a study has been made on that a coating film formed by applying a solution of an inorganic precursor compound onto a base material and then drying is modified by heat or light so as to improve the gas barrier property. In particular, a study has been also made on that a high gas barrier property is intended to be expressed by using polysilazane as an inorganic precursor compound.

Polysilazane is a compound having - ($SiH_2$-NH) - as a basic structure (for example, the case of perhydropolysilazane). When polysilazane is subjected to a heat treatment or a moist heat treatment under an oxidizing atmosphere, polysilazane changes to silicon oxide by way of silicon oxynitride. In this case, since nitrogen is directly substituted with oxygen by oxygen and water vapor under the atmosphere, polysilazane changes to silicon oxide in the state of comparatively small volume shrinkage. As a result, a relatively dense film can be obtained with a few defects in the film due to the volume shrinkage. Moreover, by controlling an oxidizing property of atmosphere, it is also possible to obtain a relatively dense silicon oxynitride film.

However, the formation of a dense silicon oxynitride film or silicon oxide film by thermal modification or wet heat modification of polysilazane requires a high temperature of 450°C or higher and is not possible to be applied to a flexible base material such as a plastic film.

As a means for solving such a problem, there is proposed a method for forming a silicon oxynitride film or a silicon oxide film by performing vacuum ultraviolet light (hereinafter, also referred to as "VUV" or "VUV light") irradiation on a coating film formed by applying a polysilazane solution.

In this case, since the vacuum ultraviolet light (wavelength of 100 to 200 nm) has larger light energy than

bonding force between respective atoms of polysilazane, according to the above method, an oxidation reaction due to active oxygen or ozone can be allowed to proceed while directly cutting an atomic bond by an action of only photon, which is called a light quantum process. Therefore, a silicon oxynitride film or a silicon oxide film can be formed at a relatively low temperature. In addition, this method is suitable for production in a roll-to-roll manner with favorable productivity.

Non-Patent Literature 1 discloses a method for producing a gas barrier film by irradiating a polysilazane coating film with VUV light using an excimer lamp. However, layer configurations and producing conditions are not discussed in detail so that the gas barrier property of the obtained gas barrier film is far below the gas barrier property that is required for a flexible electronic device.

Patent Literature 1 discloses a method for producing a gas barrier film by irradiating a polysilazane coating film containing a basic catalyst with VUV light and UV light. In addition, in Examples, there is also exemplified an example of a gas barrier film formed by laminating three gas barrier layers formed by applying polysilazane onto a resin base material, followed by drying and subjecting VUV light irradiation. However, the gas barrier property of this film is also far below the gas barrier property that is required for a flexible electronic device.

Patent Literature 2 discloses a gas barrier film produced by laminating two or more gas barrier layers, which are obtained by irradiating a polysilazane coating film having a film thickness of 250 nm or less with VUV light, on a resin base material having a smooth surface (surface Ra value is less than 12 nm). By making the surface of the base material a smooth surface, even when a polysilazane coating film is thinned, protrusions on the surface of the base material are not penetrated and exposed from the polysilazane coating film and thus it is considered that an effect of improving a gas barrier property to some extent can be obtained. However, the gas barrier property is far below the level of the gas barrier property that is required for a flexible electronic device, as was expected.

As described above, a gas barrier film having a gas barrier property that is required for a flexible electronic device and further having favorable productivity has not been obtained hitherto, and, as the case now stands, there is a demand for development of a means for providing such a gas barrier film.

Further, in recent years, efforts are also under way to develop a display (OLED display) using an organic electroluminescence (EL) element formed of an organic thin film. In order to make use of the advantage of the organic thin film, alternation from a glass substrate to a plastic substrate, combining of members, or the like has been studied so that a substrate to be used for these displays becomes light-weight, is prevented from breaking, and has flexibility.

A substrate for an OLED display requires a very high gas barrier property that is also considered to be a water vapor transmission rate (WVTR) of $10^{-6}$g/m$^2$/day. Patent Literature 3 discloses a method of alternately laminating, on a resin substrate, a dense inorganic layer exerting a gas barrier property and a photocurable organic layer for resetting a defect of the inorganic layer and exhibiting a maze effect, in order to achieve a very high gas barrier property as described above.

Meanwhile, in the OLED display, a reflection type electrode is used as an electrode at a side opposite to the view side. Further, outside light may be reflected at the interface between the organic layer and the inorganic layer in some cases. Therefore, in the case of use under outside light, there is a problem in a decrease in contrast due to outside light reflection. Furthermore, the same problem of the outside light reflection may occur in a semi-transmissive liquid crystal display device or a display device provided with a touch panel at the view side (since a touch panel has a transparent conductive film having a high refractive index, the reflectance is high at the interface thereof and thus the outside light reflection is problematic). As a means for suppressing such outside light reflection, for example, there has been proposed a method of disposing a circular polarizing plate at the view side of the OLED display, or the like. The circular polarizing plate has a configuration of laminating a linear polarizing plate (polarizer) and a λ/4 phase difference plate (λ/4 phase difference film), and in this application, the λ/4 phase difference plate is disposed to be positioned at a light emitting element side. According to this, incident outside light is converted into circularlypolarized light bypassing through the circular polarizing plate, and in the case of the internal reflection, a phase of the circularly polarized light is reversed. Then, when the circularly polarized light, which has been internally reflected (light in which the phase is reversed) is returned to linearly polarized light again by the λ/4 phase difference plate, the light cannot pass through the linear polarizing plate (polarizer) any more, and the incident outside light is confined in the inside of the circular polarizing plate. As a result, a decrease in contrast due to the internal reflection of outside light may be prevented.

If the λ/4 phase difference plate constituting the circular polarizing plate as described above is used as a base material and it is possible to provide the above-described gas barrier film capable of achieving an extremely high level of gas barrier property, it is theoretically possible to combine a function of the display- side base material of the OLED display and a function of the λ/4 phase difference plate as a configuration element of the circular polarizing plate with the above-described gas barrier film. However, a technique for providing a high level of gas barrier property as described above to a phase difference film has not yet been known. Moreover, regarding the internal reflection in the OLED display or the like as described above, as the case now stands, the internal reflection is demanded to further reduce.

Furthermore, Patent Literature 4 discloses a technique of providing a gas barrier property to a phase difference film in liquid crystal display fields. In Patent Literature 4, when a gas barrier layer having a WVTR lower than 0.005

g/m$^2$/day is provided on a phase difference film formed of a cycloolefin polymer (COP) by physical vapor deposition, followed by being used as a display-side optical compensation film, a viewing angle in a flexible liquid crystal display is improved by combining a function of the substrate and a function of the optical compensation film.

## Citation List

### Patent Literature

Patent Literature 1: International Publication No. WO 2007/012392
Patent Literature 2: Japanese Patent Application Laid-Open No. 2009-255040
Patent Literature 3: US Patent No. RE40531
Patent Literature 4: Japanese Patent Application Laid-Open No. 2003-195271

### Non-Patent Literature

Non-Patent Literature 1: Leibniz Institute of Surface Modification Biannual Report 2008/2009: P18-P21

## SUMMARY OF INVENTION

### Technical Problem

As described above, Patent Literature 3 discloses a method in which a dense inorganic layer and a photocurable organic layer are alternately laminated on a resin substrate so as to provide a gas barrier property. However, according to the studies of inventors of the present invention, even in the case of using the method described in Patent Literature 3, it was found that three inorganic layers and two organic layers, that is, five layers in total are necessary in order to achieve the level of $1 \times 10^{-5}$ g/m$^2$/day to $10^{-6}$ g/m$^2$/day. Therefore, this technique has a problem in terms of productivity. Moreover, there are a large number of interfaces between inorganic layers and organic layers which have poor adhesiveness. According to this, it was also found that, when an external force such as a bending force is applied, a decrease in the gas barrier property, which is considered to be caused due to micro peeling, occurs.
Furthermore, the inventors of the present invention have studied in order to solve the above problems, and as a result, also found that materials which are generally used as constituent materials for a $\lambda$/4 phase difference plate or a linear polarizing plate have a small stiffness (rigidity) of a film and, when a multi-layered gas barrier unit is provided by employing a configuration in which an inorganic layer and an organic layer are alternately laminated in a similar manner to the technique described in Patent Literature 3, curl or deformation of the film becomes larger, and thus the film is not easy to be handled in a device manufacturing step.
Further, as described before, the gas barrier property of the gas barrier layer formed by the film formation method of Patent Literature 4 is also far below the level of the gas barrier property that is required for the OLED display. As described above, in addition to Patent Literature 4, in gas barrier layers formed by conventionally well-known film formation methods including a vapor deposition method such as a CVD method, as the case now stands, the high barrier property required for the OLED display cannot be compatible with the sufficient internal reflection suppressing effect.
The present invention is made in view of the above-described problems, and an object thereof is toprovide a gas barrier film which includes a film having optical anisotropy as a base material, has very excellent gas barrier performance and favorable productivity, and is applicable for an OLED display and also excellent in visibility. Further, another object of the present invention is also to provide a substrate for an electronic device using such a gas barrier film which is excellent in durability and visibility of an image, is lightweight and not broken unlike glass, and is used for an electronic device such as a display device, and further an electronic device such as a display device (for example, OLED display) using the same.

Solution to Problem

The above object of the present invention is achieved by the following configuration.

1. A gas barrier film including a film base material having optical anisotropy, and a gas barrier unit disposed on at least one surface of the film base material, in which the gas barrier unit includes, from the side of the film base material, a first barrier layer containing an inorganic material and a second barrier layer obtained by performing a conversion treatment to a coating film formed by applying polysilazane;

2. The gas barrier film described in the above item 1, in which the film base material is a λ/4 phase difference plate;
3. The gas barrier film described in the above item 1 or 2, in which the conversion treatment is a treatment of irradiation with a vacuum ultraviolet ray;
4. The gas barrier film described in any one of the above items 1 to 3, in which a constituent material of the film base material includes one or two or more kinds selected from the group consisting of polycarbonate, a cycloolefin polymer, a cycloolefin copolymer, and a cellulose derivative;
5. The gas barrier film described in the above item 4, in which the constituent material of the film base material includes polycarbonate, and the film further comprises a smoothing layer having no optical anisotropy and disposed between the film base material and the first barrier layer;
6. The gas barrier film described in any one of the above items 1 to 5, in which a linear polarizing plate is further disposed at a side opposite to the gas barrier unit of the film base material;
7. A substrate for an electronic device including the gas barrier film described in the above item 6, and a transparent electrode disposed at the side of the gas barrier unit constituting the gas barrier film, which is opposite to the film base material; and
8. An electronic device using the gas barrier film described in any one of the above items 1 to 6 or the substrate for an electronic device described in the above item 7.

BRIEF DESCRIPTION OF DRAWINGS

Fig. 1 is a cross-sectional schematic diagram of a gas barrier film according to an embodiment of the present invention.
Fig. 2 is a cross-sectional view schematically illustrating an example of a vacuum ultraviolet illumination apparatus which is used in the present invention.

DESCRIPTION OF EMBODIMENTS

Hereinafter, embodiments for carrying out the present invention will be described in detail, but the scope of the present invention is not restricted to the description. Embodiments other than the following examples may be also appropriately implemented in the scope without departing from the gist of the present invention.

Incidentally, in the present specification, the terms "a vacuum ultraviolet ray," "vacuum ultraviolet light, " "VUV, " and "VUV light" mean light having a wavelength of 100 to 200 nm, specifically. In addition, the term "X to Y" indicating the range means "X or more but Y or less. "

Inventors of the present invention conducted intensive studies in view of the problems described above. As a result, they found that a gas barrier film, which is excellent in productivity and has also a function as a phase difference film while having an extremely excellent gas barrier property, can be realized in such a manner that a gas barrier unit is formed by disposing, on a film base material (phase difference film) having optical anisotropy, a first barrier layer containing an inorganic material and a second barrier layer obtained by performing a conversion treatment to a coating film formed by applying polysilazane in this order, and the present invention is achieved.

Hereinafter, the details of configuration elements of the gas barrier film of the present invention will be described.

«Gas Barrier Film»

The gas barrier film of the present invention has a gas barrier unit on a film base material (phase difference film) having optical anisotropy, particularly, on a film base material serving as a λ/4 phase difference plate used for a circular polarizing plate, the gas barrier unit including, from the film base material side, a first barrier layer containing an inorganic material and a second barrier layer obtained by performing a conversion treatment to a coating film formed by applying polysilazane. Further, the gas barrier film may have a configuration in which the above-described gas barrier unit is provided on both surfaces of the base material. According to the gas barrier film of the present invention, there is provided a gas barrier film, including a phase difference film as a base material, which has very excellent gas barrier performance and favorable productivity and is applicable for an OLED display. Moreover, according to the present invention, there are provided a substrate for an electronic device using such a gas barrier film which is excellent in durability and visibility of an image, is lightweight and not broken unlike glass, and is used for an electronic device such as a display device, and further an electronic device such as a display device (for example, OLED display) using the same.

As an advantage in the case of using the gas barrier film of the present invention, for example, when the gas barrier film of the present invention is used as a display-side substrate of an OLED display, there is an advantage that a film can be thinned remarkably by combining members. In the case of the simplest configuration, the current configuration at the display side from the element of the OLED display is a display-side glass substrate/an adhesion layer/a

λ/4 plate/an adhesion layer/a polarizing plate. On the other hand, when the gas barrier film of the present invention is used, it is possible to have a configuration of the gas barrier film of the present invention/an adhesion layer/a polarizing plate, and the thickness of this portion can be reduced to about 30%. Moreover, as described above, the gas barrier film of the present invention is not broken unlike glass and is becoming lighter in weight. Accordingly, when the gas barrier film of the present invention is applied, particularly, to a display device to be mounted to a mobile device, a great advantage may be obtained.

Further, according to the gas barrier film of the present invention, when the gas barrier film is used as a display-side substrate of an OLED display, it is possible to exhibit an excellent effect of suppressing internal reflection and to considerably improve visibility of a display device. In a case where only a gas barrier layer formed by a conventionally well-known vapor deposition method such as a CVD method (corresponding to "the first barrier layer containing an inorganic material" in the present invention) is disposed, it is not possible to sufficiently reduce such internal reflection. It is considered that this is caused due to unevenness present on the surface of the gas barrier layer. On the other hand, a mechanism in which an excellent effect of suppressing internal reflection is expressed by employing the configuration of the present invention is presumed as follows. That is, it is presumed that an excellent effect of suppressing internal reflection is exhibited because unevenness of the surface of the first barrier layer is covered in such a manner that "the second barrier layer obtained by performing a conversion treatment to a coating film formed by applying polysilazane" is formed on the first barrier layer containing an inorganic material, and further unevenness of the second barrier layer is small.

Fig. 1 is a cross-sectional schematic diagram of a gas barrier film according to an embodiment of the present invention. As illustrated in Fig. 1, the gas barrier film according to the present embodiment is configured by including a film base material 1 as a support, and a smoothing layer 2, a first barrier layer 3 containing an inorganic material (for example, $SiO_x$), and a second barrier layer 4 obtained by performing a conversion treatment to a coating film formed by applying polysilazane which are sequentially disposed on one surface of the film base material 1, and a linear polarizing plate (polarizer) 5 disposed on the other surface of the film base material 1. Further, the film base material 1 is a film base material having optical anisotropy (phase difference film; typically, λ/4 phase difference plate).

Hereinafter, the details of configuration elements of the gas barrier film of the present invention will be described.

[Film Base Material]

The film base material used for the gas barrier film according to the present embodiment has optical anisotropy. Here, the expression "the film base material has optical anisotropy" means that refractive indexes are different in an in-plane direction or in the in-plane direction and a thickness direction. Preferably, the film base material is a support the length of which can be elongated, and can hold a barrier layer having a gas barrier property (also simply referred to as the "barrier property") to be described later. Further, it is preferable that the filmbase material be a polymer film having negative wavelength dispersibility in which a phase difference in the film surface decreases as a wavelength becomes a short wavelength. Furthermore, it is particularly preferable to use a polymer film which is controlled such that an in-plane phase difference (Ro) is λ/4 with respect to light having a wavelength of 550 nm. Incidentally, the expression "the in-plane phase difference (Ro) is λ/4 with respect to light having a wavelength of 550 nm" in this specification means that a value of Ro to be obtained by the following formula is 148 ± 10 nm.

[Mathematical Formula 1]

$$Ro = (nx - ny) \times d$$

In the formula, d represents a film thickness (nm) of the film base material, nx represents the in-plane maximum refractive index of the film base material (also referred to as a refractive index in a phase retardation axial direction), and ny represents an in-plane refractive index of the film in a direction perpendicular to the phase retardation axis. In addition, Ro is measured using KOBRA-21 ADH (manufactured by Oji Scientific Instruments) as an automatic double refractometer under the environment of 23°C and 55%RH at a measurement wavelength of 550 nm.

Examples of the constituent material of the film base material, which has reverse wavelength dispersibility as described above and can provide optical properties as the λ/4 phase difference plate, include one or two or more kinds selected from the group consisting of cellulose derivatives such as polycarbonate (PC), a cycloolefin polymer (COP), a cycloolefin copolymer (COC), and cellulose acetate phthalate (CAP). Moreover, it is possible to use, as the film base material, a film-formed material formed by subjecting these materials to a stretching treatment and aligning a polymer molecule or a film formed by aligning a liquid crystal material on a base material formed of a film expressing no phase difference and then curing such that a desired optical property is expressed.

Among them, from the viewpoint of cost and purchase easiness, and improvement of gas barrier property,

polycarbonate (PC) or a cycloolefin polymer (COP) is preferably used. PURE-ACE WR manufactured by Teijin Chemicals Ltd. is exemplified as a polycarbonate (PC) film having a function as the λ/4 phase difference plate, ZEONOR Film manufactured by Zeon Corporation and F Film manufactured by GUNZE LIMITED are exemplified as a cycloolefin polymer (COP) film, and all products can be easily purchased.

The refractive index of the film base material having optical anisotropy, which is used in the present invention, with respect to sodium d-line (589 nm) is preferably 1.57 to 1.62. When the refractive index is 1.57 or more, a value of double refraction is maintained to be sufficiently high. Meanwhile, when the refractive index is 1.62 or less, reflectance does not become too large and thus light transmission properties are secured sufficiently.

Further, in the film base material having optical anisotropy used in the present invention, a ratio of the phase difference R450 measured at a wavelength of 450 nm to the phase difference R550 measured at a wavelength of 550 nm (R450/R550) is preferably 0.75 to 1.1. When the ratio is within this range, almost ideal phase difference characteristics can be obtained. For example, when a circular polarizing plate is prepared using the film base material having optical anisotropy as a λ/4 phase difference plate, not only it is possible to provide a λ/4 phase difference plate which is ideal in the visible region but also it is possible to realize the polarizing plate and a display device which have small wavelength dependence and have neutral hues. In order to more stably obtain this effect, the ratio (R450/R550) is more preferably 0.76 to 0.98, and particularly preferably 0.77 to 0.95.

Further, a photoelastic coefficient of the film base material having optical anisotropy used in the present invention is preferably $40 \times 10^{-12}$ $Pa^{-1}$ or less. When the photoelastic coefficient is $40 \times 10^{-12}$ $Pa^{-1}$ or less, the following problem may arise when the film base material is laminated as a phase difference film to a linear polarizing plate (polarizer) and the linear polarizing plate is mounted in a display device. Due to the stress caused during the laminating, partial stress is imposed on the phase difference film by heat of the environment in which the display device is used or of the backlight, An uneven change in phase difference hence occurs, resulting in a considerable decrease in image quality. From such a viewpoint, the photoelastic coefficient of the film base material in the present invention is preferably $40 \times 10^{-12}$ $Pa^{-1}$ or less, and more preferably $35 \times 10^{-12}$ $Pa^{-1}$ or less.

The thickness of the film base material is preferably about 5.0 to 500 μm, and more preferably 25 to 250 μm.

Further, the film base material is preferably transparent. The expression "the film base material is transparent" used herein means that a light transmission rate of visible light (400 to 700 nm) is80%ormore. According to such an embodiment, it is possible to obtain a transparent gas barrier film by using a transparent film as a gas barrier unit to be formed on the film base material. As a result, the obtained transparent gas barrier film can be also used for manufacturing a transparent substrate of an organic EL element or the like.

Further, the surf ace of the film base material used in the present invention may be subjected to a corona treatment before forming the gas barrier unit.

As a surface roughness of the film base material used in the present invention, a ten-point average roughness Rz specified in JIS B 0601 (2001) is preferably in a range of 1 to 500 nm, and more preferably in a range of 5 to 400 nm. The ten-point average roughness Rz is still more preferably in a range of 300 to 350 nm.

Further, a center line average surface roughness Ra of the surface of the film base material specified in JIS B 0601 (2001) is preferably in a range of 0.5 to 12 nm, and more preferably in a range of 1 to 8 nm. In order to achieve such a surface roughness, a well-known smoothing technique can be used. For example, a technique can be used in which a smoothing layer is disposed by providing a coating film between the film base material and the first barrier layer, smoothing the surface through leveling, and then curing the smoothed surface.

[First Barrier Layer]

The first barrier layer according to the present invention contains an inorganic material. Examples of the inorganic material contained in the first barrier layer include, although not particularly limited, metal oxide, metal nitride, metal carbide, metal oxide-nitride, or metal oxide-carbide. Among them, in terms of the gas barrier performance, it is preferable to use oxides, nitrides, carbides, oxide-nitrides, or oxide-carbides including one or more metals selected from Si, Al, In, Sn, Zn, Ti, Cu, Ce and Ta. Oxides, nitrides, or oxide-nitrides of a metal selected from Si, Al, In, Sn, Zn and Ti are more preferably used, and, in particular, oxides, nitrides, or oxide-nitrides of at least one of Si and Al are preferably used. Specific examples of a preferred inorganic material include silicon oxide, silicone nitride, silicon oxynitride, aluminum oxide, or aluminum silicate.

As still more preferable oxide-nitrides, silicon oxynitride is exemplified. Here, silicon oxynitride indicates a composition consisting of silicon, oxygen, and nitrogen as main constituent elements. Each of constituent elements, other than the above elements, such as a small amount of hydrogen or carbon, which is introduced from raw materials for film formation, a base material, atmosphere, or the like, is desirably less than 5%. When the composition formula of silicon oxynitride is expressed as $SiO_xN_y$, the composition ratio of silicon, oxygen, and nitrogen constituting silicon oxynitride, that is, x/y is preferably 0.2 to 5. 5. When x/y is 5. 5 or less, sufficient gas barrier performance can be easily obtained. Further, when x/y is 0.2 or more, peeling between adjacent layers does not occur easily. Accordingly, it is

likely to obtain a film which can be also preferably applied to roll conveyance or curved usage. Incidentally, the element composition ratio of a lamination sample can be measured according to a well-known standard technique by X-ray photoelectron spectroscopy (XPS) while etching is carried out.

The content of the inorganic material contained in the first barrier layer is not particularly limited, but the content of the inorganic material in the first barrier layer is preferably 50% by mass or more, more preferably 80% by mass or more, even more preferably 95% by mass or more, particularly preferably 98% by mass or more, and most preferably 100% by mass (that is, the first barrier layer is formed of an inorganic material).

The refractive index of the first barrier layer is preferably 1.7 to 2.1, and more preferably 1.8 to 2.0. In particular, when the refractive index is 1.9 to 2.0, visible light transmission is high and high gas barrier performance can be stably achieved, which is most preferable.

The flatness of the first barrier layer according to the present invention is preferably less than 1 nm in terms of the average roughness (Ra value) of a 1 $\mu$m $\times$ 1 $\mu$m area, and more preferably 0.5 nm or less.

The first barrier layer is preferably formed in a clean room. The cleanliness class is preferably a class 10,000 or less, and more preferably 1,000 or less.

The thickness of the first barrier layer is not particularly limited, but in general, the thickness thereof is within a range of 5 to 500 nm, and is preferably 10 to 200 nm.

The first barrier layer may have a laminate structure formed of plural sub layers. In this case, the respective sub layers may have the same composition or different compositions. In a case where the first barrier layer includes a sub layer, the number of sub layers is generally about 1 to 100.

As for the method for forming the first barrier layer, any methods can be employed as long as they can form a target thin film. Among them, it is preferable that the first barrier layer be formed by any one method of a chemical vapor deposition method, a physical vapor deposition method, and an atomic layer deposition method. In the present invention, the second barrier layer to be described later can be obtained by modifying polysilazane. Therefore, by forming the first barrier layer by a different mechanism from that in the second barrier layer, it is possible to make film formation states of adjacent layers different from each other. As a result, gas passages in the layers may be different between the adjacent layers, and thus the gas barrier performance is further improved.

The physical vapor deposition method (PVD) is a method of depositing a target substance, for example, a thin film such as a carbon film, on a surface of a substance in a vapor phase by a physical procedure, and examples thereof include a sputtering method (DC sputtering, RF sputtering, ion beam sputtering, magnetron sputtering, or the like), a vacuum vapor deposition method, an ion plating method, and the like.

In the sputtering method, a target is arranged in a vacuum chamber, an ionized noble gas element (usually, argon) obtained by applying a high voltage is allowed to collide with the target and atoms on the target surface are sputtered so as to attach to a base material. In this case, a reactive sputtering method in which, by flowing a nitrogen gas or an oxygen gas in the chamber, an element sputtered from the target by an argon gas is reacted with nitrogen and oxygen so as to form an inorganic layer may also be used.

Meanwhile, the chemical vapor deposition (CVD) method is a method of supplying a raw material gas containing a component of a target thin film to the base material and depositing a film by chemical reaction on the substrate surface or gas phase. Further, there is a method of generating plasma or the like for the purpose of activating the chemical reaction, and examples thereof include a plasma CVD method, a laser CVD method, a thermal CVD method, and the like.

As a raw material gas, a raw material gas becoming a desired inorganic layer may be appropriately selected, and for example, examples thereof include a metal compound such as a silicon compound, a titanium compound, a zirconium compound, an aluminum compound, a boron compound, a tin compound, or an organometallic compound.

Among them, examples of the silicon compound include silane, tetramethoxysilane, tetraethoxysilane, tetra-n-propoxysilane, tetraisopropoxysilane, tetra-n-butoxysilane, tetra-t-butoxysilane, dimethyldimethoxysilane, dimethyldiethoxysilane, diethyldimethoxysilane, diphenyldimethoxysilane, methyltriethoxysilane, ethyltrimethoxysilane, phenyltriethoxysilane, (3,3,3-trifluoropropyl)trimethoxysilane, hexamethyldisiloxane, bis(dimethylamino)dimethylsilane, bis(dimethylamino)methylvinylsilane, bis(ethylamino)dimethylsilane, N,O-bis(trimethylsilyl)acetamide, bis(trimethylsilyl)carbodiimide, diethylaminotrimethylsilane, dimethylaminodimethylsilane, hexamethyldisilazane, hexamethylcyclotrisilazane, heptamethyldisilazane, nonamethyltrisilazane, octamethylcyclotetrasilazane, tetrakisdimethylaminosilane, tetraisocyanatesilane, tetramethyldisilazane, tris(dimethylamino)silane, triethoxyfluorosilane, allyldimethylsilane, allyltrimethylsilane, benzyltrimethylsilane, bis(trimethylsilyl)acetylene, 1,4-bistrimethylsilyl-1,3-butadiyne, di-t-butylsilane, 1,3-disilabutane, bis(trimethylsilyl)methane, cyclopentadienyltrimethylsilane, phenyldimethylsilane, phenyltrimethylsilane, propargyltrimethylsilane, tetramethylsilane, trimethylsilylacetylene, 1-(trimethylsilyl)-1-propine, tris(trimethylsilyl)methane, tris(trimethylsilyl)silane, vinyltrimethylsilane, hexamethyldisilane, octamethylcyclotetrasiloxane, tetramethylcyclotetrasiloxane, hexamethylcyclotetrasiloxane, M silicate 51, and the like.

Examples of the aluminum compound include aluminum ethoxide, aluminum triisopropoxide, aluminum isopropoxide, aluminum n-butoxide, aluminum s-butoxide, aluminum t-butoxide, aluminum acetylacetonate, triethyldialuminum tri-s-butoxide, and the like.

In general, in a conventional gas barrier laminate of organic-inorganic layer laminated type, when an inorganic layer is formed by a physical vapor deposition method or a chemical vapor deposition method, there is a problem in that a desired barrier property may not be obtained. It is considered that pinholes or damages may occur in a generated thin film because the above-described sputtering method or CVD method uses high energy particles.

However, in the gas barrier film of the present invention, the second barrier layer is disposed by applying a polysilazane coating liquid onto the first barrier layer, followed by being subjected to the conversion. Accordingly, a pathway for gas passing through minute defects is blocked and thus even when a film is formed using the first barrier layer containing an inorganic material by a physical vapor deposition method or a chemical vapor deposition method, high barrier properties can be maintained.

An atomic layer deposition method (hereinafter, also referred to as an "ALD method") is a method of using chemical adsorption and chemical reaction of plural low energy gases with respect to a base material surface. Since this method is a method of using plural low energy gases, the method has advantages that pinholes or damages less easily occur and a high-density monoatomic film can be obtained, whereas pinholes or damages may occur in a generated thin film because the above-described sputtering method or CVD method utilizes high energy particles (see Japanese Patent Application Laid-Open No. 2003-347042, PCT Japanese Translation Patent Publication No. 2004-535514, and International PublicationNo. WO 2004/105149). Therefore, by forming the first barrier layer by the ALD method, the water vapor barrier performance (WVTR) is improved, which is favorable.

In the ALD method, plural gases are alternately switched and supplied onto a base material, a monoatomic layer (gas molecule layer) is formed on the base material by chemical adsorption, and an inorganic layer is formed layer-by-layer on the base material by chemical reaction. For example, in the case of alumina, trimethylaluminum (TMA), triethylaluminum (TEA), trichloroaluminum, or the like can be used as an Al source, and water ($H_2O$) or the like can be used as an oxygen (O) source. By alternately introducing two types of gas molecules on the substrate, a thin film is formed on the substrate. When switching of gases is carried out, it is preferable that a system be purged with an inert gas such as nitrogen so as to remove excess gas in the system. A film formation temperature is preferably a high temperature to some extent because activation of the base material surface is required for adsorption of gas molecules to the base material. The film formation temperature may be appropriately adjusted within the range not exceeding a glass transition temperature or decomposition starting temperature of a plastic substrate as a base material.

[Second Barrier Layer (also called a "polysilazane layer" in the present specification)]

The second barrier layer is a layer disposed by performing a conversion treatment to a coating film formed by applying polysilazane to the side of the first barrier layer opposite to the film base material.

As amethod for applying a coating liquid containing polysilazane (in the present specification, referred to as a polysilazane coating liquid) (for example, onto the first barrier layer) in the formation of the polysilazane layer, any suitable wet type coating methods may be adopted. Specific examples thereof include a spin coating method, a roll coating method, a flow coating method, an inkjet method, a spray coating method, a printing method, a dip coating method, a flow casting film formation method, a bar coating method, a gravure printing method, and the like.

A coated film thickness may be appropriately set depending on the purpose. For example, the coated film thickness is appropriately set so that the thickness after drying is preferably about 10 nm to 10 $\mu$m, and more preferably 50 nm to 1 $\mu$m. When the film thickness of the polysilazane layer is 10 nm or more, it is possible to obtain sufficient barrier properties. When the film thickness of the polysilazane layer is 10 $\mu$m or less, it is possible to obtain stable coating properties during the formation of the polysilazane layer and to realize high light transmission properties.

(Polysilazane)

Hereinafter, polysilazane will be described.

Polysilazane which is a polymer having a silicon-nitrogen bond is a ceramic precursor inorganic polymer having a bond of Si-N, Si-H, N-H, or the like, such as $SiO_2$, $Si_3N_4$, and an intermediate solid solution $SiO_xN_y$ therebetween.

As polysilazane, it is preferable to use a compound having a structure represented by the following General Formula (I).

[Chem. 1]

General Formula (I) $-(SiR_1R_2-NR_3)_n-$

In the above General Formula (I), $R_1$, $R_2$, and $R_3$, which are identical to or different from each other, each independently represent a hydrogen atom; a substituted or unsubstituted alkyl group, aryl group, vinyl group, or (trialkoxysilyl)alkyl group. Here, examples of the alkyl group include a linear, branched, or cyclic alkyl group having 1 to 8 carbon atoms. Specific examples thereof include a methyl group, an ethyl group, an n-propyl group, an isopropyl group, ann-butyl group, an isobutyl group, a sec-butyl group, a tert-butyl group, an n-pentyl group, an isopentyl group, a neopentyl group, an n-hexyl group, an n-heptyl group, an n-octyl group, a 2-ethylhexyl group, a cyclopropyl group, a cyclopentyl group, a cyclohexyl group, and the like. Further, examples of the aryl group include an aryl group having 6 to 30 carbon atoms. Specific examples thereof include a non-condensed hydrocarbon group such as a phenyl group, a biphenyl group, or a terphenyl group; and a condensed polycyclic hydrocarbon group such as a pentalenyl group, an indenyl group, a naphthyl group, an azulenyl group, a heptalenyl group, a biphenylenyl group, a fluorenyl group, an acenaphthylenyl group, a pleiadenyl group, an acenaphthenyl group, a phenalenyl group, a phenanthryl group, an anthryl group, a fluoranthenyl group, an acephenanthrylenyl group, an aceanthrylenyl group, a triphenylenyl group, a pyrenyl group, a chrysenyl group, or a naphthacenyl group. Examples of the (trialkoxysilyl)alkyl group include an alkyl group having 1 to 8 carbon atoms which has a silyl group substituted with an alkoxy group having 1 to 8 carbon atoms. Specific examples thereof include 3-(triethoxysilyl)propyl group, 3-(trimethoxysilyl)propyl group, and the like. A substituent that is present in the above $R_1$ to $R_3$ depending on cases is not particularly limited, but examples thereof include an alkyl group, a halogen atom, a hydroxyl group (-OH), a mercapto group (-SH), a cyano group (-CN), a sulfo group ($-SO_3H$), a carboxyl group (-COOH), a nitro group ($-NO_2$), and the like. Note that the substituent that is present depending on cases is not the same as $R_1$ to $R_3$ to be substituted. For example, in a case where $R_1$ to $R_3$ are alkyl groups, there is no case of further substitution with an alkyl group. Among them, $R_1$, $R_2$, and $R_3$ each are preferably a hydrogen atom, a methyl group, an ethyl group, a propyl group, an isopropyl group, a butyl group, an isobutyl group, a tert-butyl group, a phenyl group, a vinyl group, a 3-(triethoxysilyl)propyl group, or a 3-(trimethoxysilyl propyl)group. $R_1$, $R_2$, and $R_3$ each independently are a group selected from the group consisting of a hydrogen atom, a methyl group, an ethyl group, a propyl group, an iso-propyl group, a butyl group, an iso-butyl group, a tert-butyl group, a phenyl group, a vinyl group, a 3-(triethoxysilyl)propyl group, and a 3-(trimethoxysilyl)propyl group.

Further, in the above General Formula (I), n is an integer, and n is defined so that polysilazane having a structure represented by General Formula (I) has a number average molecular weight of 150 to 150,000 g/mol.

One preferable embodiment in a compound having a structure represented by General Formula (I) is perhydropolysilazane (PHPS) in which all of $R_1$, $R_2$, and $R_3$ are hydrogen atoms from the viewpoint of density of an obtained polysilazane layer. Perhydropolysilazane is presumed to have a structure with a linear structure and a cyclic structure centering on 6- and 8-membered rings. The molecular weight is about 600 to 2,000 (polystyrene conversion) as a number average molecular weight (Mn). Perhydropolysilazane is a liquid or solid substance, but the state thereof is different depending on its molecular weight.

Further, as polysilazane according to the present invention, it is preferable to use a compound having a structure represented by the following General Formula (II).

[Chem. 2]

General Formula (II) $-(SiR_1R_2-NR_3)_n-(SiR_4R_5-NR_6)_p-$

In the above General Formula (II), $R_1$, $R_2$, $R_3$, $R_4$, $R_5$, and $R_6$ each independently represent a hydrogen atom, a substituted or unsubstituted alkyl group, aryl group, vinyl group, or (trialkoxysilyl) alkyl group, n and p are integers, n is defined so that polysilazane having a structure represented by General Formula (I) has a number average molecular weight of 150 to 150, 000 g/mol. The substituted or unsubstituted alkyl group, aryl group, vinyl group, or (trialkoxysilyl)alkyl group in the above description is defined in the same manner as the above General Formula (I) and thus the description thereof is not presented. Note that n and p may be the same or different.

In the above General Formula (II), a particularly preferable compound is a compound in which $R_1$, $R_3$, and $R_6$ each represent a hydrogen atom, $R_2$, $R_4$, and $R_5$ each represent a methyl group, a compound in which $R_1$, $R_3$, and $R_6$ each represent a hydrogen atom, $R_2$ and $R_4$ each represent a methyl group, and $R_5$ represents a vinyl group, and a compound in which $R_1$, $R_3$, $R_4$, and $R_6$ each represent a hydrogen atom, and $R_2$ and $R_5$ each represent a methyl group.

Furthermore, as polysilazane, it is preferable to use a compound having a structure represented by the following General Formula (III).

[Chem. 3]

General Formula (III) $-(SiR_1R_2-NR_3)_n-(SiR_4R_5-NR_6)_p-(SiR_7R_6-NR_g)_q-$

In the above General Formula (III), $R_1$, $R_2$, $R_3$, $R_4$, $R_5$, $R_6$, $R_7$, $R_8$, and $R_9$ each independently represent a hydrogen atom, a substituted or unsubstituted alkyl group, aryl group, vinyl group, or (trialkoxysilyl)alkyl group. n, p and q each are an integer, and n is defined so that polysilazane having a structure represented by General Formula (III) has a number average molecular weight of 150 to 150, 000 g/mol. The substituted or unsubstituted alkyl group, aryl group, vinyl group, or (trialkoxysilyl)alkyl group in the above description is defined in the same manner as the above General Formula (I) and thus the description thereof is not presented. Note that n, p and q may be the same or different.

In the above General Formula (III), a particularly preferable compound is a compound in which $R_1$, $R_3$, and $R_6$

each represent a hydrogen atom, $R_2$, $R_4$, $R_5$, and $R_8$ each represent amethyl group, $R_9$ represents a (triethoxysilyl) propyl group, and $R_7$ represents an alkyl group or a hydrogen atom.

Meanwhile, organopolysilazane in which a part of a hydrogen atom moiety bonded to Si is substituted with an alkyl group or the like, can be improved in adhesiveness with a base material being a base by having an alkyl group such as a methyl group and allow a hard and fragile ceramic film formed by polysilazane to have toughness, and has an advantage of suppressing occurrence of cracks even in the case of making a (average) film thickness large. These perhydropolysilazane and organopolysilazane may be appropriately selected according to uses and can be also used by mixing.

Other examples of a polysilazane compound include polysilazanes formed into ceramic at a low temperature such as silicon alkoxide adduct polysilazane obtained by reacting silicon alkoxide with the above-described polysilazane (Japanese Patent Application Laid-Open No. 5-238827), glycidol adduct polysilazane obtained by reacting glycidol (Japanese Patent Application Laid-Open No. 6-122852), alcohol adduct polysilazane obtained by reacting an alcohol (Japanese Patent Application Laid-Open No. 6-240208), metal carboxylic acid salt adduct polysilazane obtained by reacting a metal carboxylic acid salt (Japanese Patent Application Laid-Open No. 6-299118), acetyl acetonate complex adduct polysilazane obtained by reacting an acetyl acetonate complex containing a metal (Japanese Patent Application Laid-OpenNo. 6-306329), and metal fine particle adduct polysilazane obtained by adding metal fine particles (Japanese Patent Application Laid-Open No. 7-196986).

A solvent can be used for a coating liquid which is used in formation of the polysilazane layer, and a ratio of polysilazane in the solvent is generally 1 to 80% by mass, preferably 5 to 50% by mass, and particularly preferably 10 to 40% by mass of polysilazane.

Such a solvent is preferably an organic-based solvent that does not particularly contain water and reactive groups (for example, a hydroxyl group or an amine group) and is inactive to polysilazane, and an aprotic solvent is preferable.

As a solvent applicable to a polysilazane coating liquid according to the present invention, aprotic solvents can be included; for example, solvents of hydrocarbons including aliphatic hydrocarbons and aromatic hydrocarbons, such as pentane, hexane, cyclohexane, toluene, xylene, solvesso and turpentine; halogen hydrocarbon solvents such as methylene chloride and trichloroethane; esters such as ethyl acetate and butyl acetate; ketones such as acetone and methyl ethyl ketone; ethers such as tetrahydrofuran, a dibutyl ether, mono- and polyalkyleneglycol dialkyl ethers (diglymes), or a mixture of these solvents. The above-described solvents are selected according to purposes such as solubility of polysilazane and an evaporation rate of a solvent, and may be used either singly or in a mixture form of two or more of these solvents.

Polysilazane is commercially available in a state of a solution dissolved in an organic solvent, and such a commercially available product can be directly used as a polysilazane-containing coating liquid. Examples of a commercially available product include AQUAMICA(registered trademark) NN120-10, NN120-20, NAX120-20, NN110, NN310, NN320, NL110A, NL120A, NL150A, NP110, NP140, SP140, and the like manufactured by AZ Electronic Materials Co.

A catalyst may be contained in a polysilazane coating liquid, together with polysilazane. An applicable catalyst is preferably a basic catalyst, and particularly preferably N,N-diethyl ethanolamine, N,N-dimethyl ethanolamine, triethanolamine, triethylamine, 3-morpholinopropylamine or an N-heterocyclic compound. A concentration of a catalyst to be added is generally in a range of 0.1 to 10% by mol, and preferably in a range of 0.5 to 7% by mol based on polysilazane.

The following additives can be used in a polysilazane coating liquid as necessary. Examples thereof include cellulose ethers, cellulose esters; for example, ethylcellulose, nitrocellulose, cellulose acetate, and cellulose acetobutylate, natural resins; for example, rubbers and rosin resins, synthetic resins; for example, polymerized resins, condensed resins; for example, aminoplast, in particular, urea resin, melamine formaldehyde resin, alkyd resin, acrylic resin, polyester or modified polyester, epoxide, polyisocyanate, or blocked polyisocyanate, and polysiloxane.

An added amount of other additives is preferably 10% by mass or less, and more preferably 5% by mass or less, assuming that the whole amount of the second barrier layer is 100% by mass.

By using the polysilazane coating liquid, it is possible to produce a dense and glass-like layer which is excellent in a barrier action with respect to gas because there are no cracks and pores.

Then, in a case where the coating liquid contains a solvent, it is preferable that a solvent in the coating film formed of polysilazane be dried before the conversion treatment. In this case, the condition of removing moisture is acceptable. The drying temperature is preferably a high temperature from the viewpoint of quick treatment. However, in consideration of heat damage to a resin film base material, it is preferable to appropriately determine temperature and treatment time. For example, in a case where a polyethylene terephthalate base material with a glass transition temperature (Tg) of 70°C is used as a plastic base material, the heat treatment temperature can be set at 200°C or lower. The treatment time is preferably set to short time so that the solvent is removed and the heat damage to the base material is reduced, and cab be set to 30 minutes or shorter when the heat treatment temperature is 200°C or lower.

The removal of moisture in the coating film formed of polysilazane is preferably performed before the conversion

treatment or during the conversion treatment. Therefore, in the production of the polysilazane layer, it is preferable to include a step for removing moisture in the coating film (dehumidification treatment) after the drying for removing the solvent. By removing moisture before the conversion treatment or during the conversion treatment, the efficiency of the conversion treatment performed after the removal of moisture is improved.

A method for removing moisture is preferably in the form of removing moisture while maintaining a low-humidity environment. Since humidity in the low-humidity environment varies with temperature, the preferred form of the relation between the temperature and the humidity is indicated by defining dew-point temperature. The dew-point temperature is preferably 4°C or lower (temperature of 25°C/humidity of 25%), more preferably -8°C (temperature of 25°C/humidity of 10%) or lower, and maintenance time is preferably appropriately set depending on the film thickness of the polysilazane layer. It is preferable that the dew point temperature be -8°C or lower and the maintenance time be 5 minutes or longer on the condition of the film thickness of the polysilazane layer of 1.0 μm or less. Incidentally, the lower limit of the dew-point temperature is not particularly limited, but is generally -50°C or higher, and preferably -40°C or higher. In addition, in order to make it easy to remove moisture, drying under reduced pressure may be also performed. As pressure in the drying under reduced pressure, normal pressure to 0.1 MPa can be selected.

Even after moisture has been removed, the coating film is preferably subjected to the conversion treatment while maintaining the state.

(Conversion treatment)

Subsequently, the conversion treatment is performed on the obtained coating film. Here, the conversion treatment refers to a reaction of converting polysilazane into silicon oxide and/or silicon oxide-nitride. That is, it is preferable that polysilazane be converted into silica by performing the conversion treatment so as to be $SiO_xN_y$. Here, x is preferably 0.5 to 2.3, more preferably 0.5 to 2.0, and still more preferably 1.2 to 2.0. Moreover, y is preferably 0.1 to 3.0, more preferably 0.15 to 1.5, and still more preferably 0.2 to 1.3.

Here, in the conversion into silica, breakage of the Si-H and N-H bonds and generation of the Si-O bond occur, and conversion into ceramic such as silica is carried out. The degree of conversion into ceramic can be semiquantitatively evaluated using Formula (1) to be defined below by IR measurement.

[Mathematical Formula 2]

Formula (1)

SiO/SiN ratio = SiO absorbance after conversion/SiN absorbance after conversion

Here, the SiO absorbance is calculated from characteristic absorption of about 1160 $cm^{-1}$ and the SiN absorbance is calculated from characteristic absorption of about 840 $cm^{-1}$. A larger SiO/SiN ratio indicates that conversion into ceramic close to the silica composition has advanced.

The SiO/SiN ratio as an index of conversion degree into ceramic is 0.3 or more, and preferably 0.5 or more. By adjusting the ratio to be in such a range, favorable gas barrier performance is obtained.

As a measurement method of a silica conversion rate (x in SiOx), for example, the XPS method can be used for measurement.

The composition of the metal oxide (SiOx) of the second barrier layer can be measured by measuring an atom composition ratio using anXPS surface analyzer. In addition, the composition thereof can be also measured by cutting the gas barrier layer and measuring the atom composition ratio of the cut surface thereof by the XPS surface analyzer.

The method for forming a layer by converting polysilazane into silica is not particularly limited, but examples thereof include a heat treatment, a plasma treatment, an ozone treatment, an ultraviolet ray treatment, and the like. However, from the viewpoint that the conversion treatment can be efficiently performed at a low temperature range applicable for a plastic base material, the conversion treatment is performed preferably by irradiating a coating film obtained by applying a polysilazane coating liquid with ultraviolet light having a wavelength of 400 nm or less, and particularly preferably by irradiating the coating film with vacuum ultraviolet light (VUV) having a wavelength of less than 180 nm. Ozone or an active oxygen atom generated by ultraviolet rays (synonymous with ultraviolet light) has a high oxidation capacity and can form a silicon oxide film or a silicon oxynitride film having high denseness and an insulation property at low temperature.

By the ultraviolet light irradiation, $O_2$ and $H_2O$ that contribute to ceramization, an ultraviolet ray absorbing agent, and the polysilazane itself are excited and activated. Further, the ceramization of the excited polysilazane is promoted, and a ceramic film to be obtained becomes dense. The ultraviolet light irradiation is effective even if the ultraviolet light

irradiation is performed at any point in time as long as it is performed after the formation of the coating film.

(Ultraviolet Ray Irradiation Treatment)

As described above, in the conversion treatment, the ultraviolet ray irradiation treatment is preferably used, and particularly the vacuum ultraviolet ray irradiation treatment is preferably used. Here, at least one kind of ultraviolet light having a wavelength of 400 nm or less to be radiated is preferably vacuum ultraviolet ray irradiation light (VUV) having a wavelength component of less than 180 nm. In this case, it is preferable to perform the ultraviolet ray irradiation treatment in the presence of air or ozone in order to allow the silica conversion to proceed efficiently.

The ultraviolet ray irradiation may be carried out either once or carried out repeatedly twice or more times. However, the irradiation of ultraviolet light having a wavelength of 400 nm or less to be radiated is carried out at least once preferably using ultraviolet ray irradiation light (UV) having a wavelength component of 300 nm or less, and particularly preferably using vacuum ultraviolet ray irradiation light (VUV) having a wavelength component of less than 180 nm.

For example, if a radiation source having a radiation component of a wavelength of 300 nm or less such as a $Xe_2$* excimer radiator having the maximum radiation at about 172 nm or a low-pressure mercury vapor lamp having an emission line at about 185 nm is used, ozone, an oxygen radical, and a hydroxyl radical are very efficiently generated by photodegradation due to high absorption coefficient of gas in the above-described wavelength range in the presence of oxygen and/or water vapor, and thus they promote the oxidation of the polysilazane layer. Both mechanisms, that is, the breakage of the Si-N bond and the action of the ozone, oxygen radical, and hydroxyl radical may occur only after the ultraviolet ray reaches on the surface of the polysilazane layer.

For such a reason, in order to apply an ultraviolet ray (in particular, VUV radiant ray) on the layer surface in a radiation dose as high as possible, in the above-described wavelength range, it is necessary to make concentrations of oxygen and water vapor commensurate with each other so as to reduce a path length of the ultraviolet ray, as intended, by substituting ultraviolet ray (in particular, VUV radiant ray) treatment pathway with nitrogen and then adjustably supplying oxygen and water vapor thereto according to circumstances.

Here, a presumed mechanism in which the coating film containing polysilazane is converted in a vacuum ultraviolet ray irradiation process so as to be $SiO_xN_y$ will be described by means of perhydropolysilazane as an example.

Perhydropolysilazane can be expressed by the composition of "$-(SiH_2\text{-}NH)_n-$." In a case where it is expressed by $SiO_xN_y$, x is zero (0) and y is 1. In order to satisfy $x > 0$, an external oxygen source is necessary. In this regard, (i) oxygen or moisture contained in a polysilazane coating liquid, (ii) oxygen or moisture incorporated into a coating film from the atmosphere during a coating and drying process, (iii) oxygen, moisture, ozone, or singlet oxygen incorporated into a coating film from the atmosphere during the vacuum ultraviolet ray irradiation process, (iv) oxygen or moisture migrating as an outer gas from a base material side into a coating film caused by heat or the like applied during the vacuum ultraviolet ray irradiation process, or (v) in a case where the vacuum ultraviolet ray irradiation process is performed in a non-oxidative atmosphere, when a shift is made from the non-oxidative atmosphere to an oxidative atmosphere, oxygen or moisture incorporated into a coating film from the atmosphere, becomes an oxygen source.

On the other hand, as for y, since the condition on which nitriding of Si proceeds is considered to be highly extraordinary compared with oxidation thereof, an upper limit of y is basically 1.

Further, in view of the relation among bonding arms of Si, O, and N, x and y are basically in a range of $2x + 3y \leq 4$. In the state of $y = 0$ in which oxidation has completely proceeded, a silanol group is contained in the coating film, and there may be a case in which x is in a range of $2 < x < 2.5$.

A reaction mechanism presumed to be involved with an occurrence of silicon oxynitride, and further an occurrence of silicon oxide, from perhydropolysilazane by the vacuum ultraviolet ray irradiation process will be described below.

(I) Dehydrogenation and Formation of Si-N Bond Accompanied Therewith

It is considered that a Si-H bond or N-H bond in perhydropolysilazane is relatively easily broken by excitation or the like by vacuum ultraviolet ray irradiation and binds again as Si-N under an inert atmosphere (non-bonding arm of Si may be also formed). That is, it is cured as a $SiN_y$ composition without oxidation. In this case, breakage of a polymer main chain does not occur. Breakage of the Si-H bond or N-H bond is promoted by presence of a catalyst or by heating. The broken H is released as $H_2$ to the outside of the film.

(II) Formation of Si-O-Si Bond by Hydrolysis and Dehydration Condensation

The Si-N bond in the perhydropolysilazane is hydrolyzed by water and then a polymer main chain is broken, thereby forming Si-OH. According to dehydration condensation of two of Si-OH, a Si-O-Si bond is formed and cured. Although the reaction occurs also in air, it is considered that, during vacuum ultraviolet ray irradiation under an inert

atmosphere, water vapor generated as an out gas from a base material by heat of irradiation is a main source of moisture. When moisture is present in an excessive amount, Si-OH not consumed by dehydration condensation remains, and thus a curing film with a low gas barrier property that is represented by the composition of $SiO_{2.1}$ to $SiO_{2.3}$ is yielded.

(III) Direct Oxidation and Formation of Si-O-Si Bond by Singlet Oxygen

When a suitable amount of oxygen is present in the atmosphere during vacuum ultraviolet ray irradiation, singlet oxygen having greatly high oxidizing ability is formed. H and N in perhydropolysilazane are replaced with O to form a Si-O-Si bond, and thus causing curing. It is also considered that recombination of bonds may also occur according to breakage of a polymer main chain.

(IV) OxidationAccompaniedwithSi-NBondBreakage Caused by Vacuum Ultraviolet Ray Irradiation and Excitation

It is considered that, since the energy of vacuum ultraviolet ray is greater than the bond energy of Si-N in perhydropolysilazane, the Si-N bond is broken and oxidized to generate a Si-O-Si bond or a Si-O-N bond when an oxygen source, such as oxygen, ozone, or water, is present in its surrounding. It is considered that recombination of bonds may also occur according to breakage of a polymer main chain.

Adjustment of the composition of silicon oxynitride in a layer which is obtained by performing vacuum ultraviolet ray irradiation on a coating film containing polysilazane can be carried out by controlling an oxidation state by combining appropriately the oxidation mechanisms (I) to (IV) described above.

In the vacuum ultraviolet ray irradiation step, by the excellent barrier action with respect to a gas, particularly, water vapor, the polysilazane layer (amorphous polysilazane layer) coated in the manner as described above is converted into a glass-like mesh structure of silicon dioxide. By directly initiating the oxidative conversion from a polysilazane skeleton to a three-dimensional $SiO_x$ mesh structure by using VUV photons, the conversion is made within an extremely short time in a single step.

(Vacuum Ultraviolet Ray Irradiation Treatment: Excimer Irradiation Treatment)

The most preferable conversion treatment is a treatment by vacuum ultraviolet ray irradiation (excimer irradiation treatment). The treatment by vacuum ultraviolet ray irradiation is a method for forming a silicon oxide film at a relatively low temperature (about 200°C or lower) using light energy with a wavelength of 100 to 200 nm which is larger than interatomic bond energy, and preferably using light energy with a wavelength of 100 to 180 nm by progressing an oxidation reaction by active oxygen, ozone, and the like while directly cutting an atomic bond by an action of only photon, which is called a light quantum process.

When the excimer irradiation treatment is performed, it is preferable to concurrently perform a heat treatment for promoting silica conversion. Examples of the heating treatment include a method of heating a coating film with heat conduction by bringing a substrate into contact with a heat generator such as a heat block, a method of heating the atmosphere by an external heater with resistance wire or the like, a method using light in an infrared region such as an IR heater, and the like. However, the heat treatment is not particularly limited. Further, a method capable of maintaining smoothness of a coating film containing a silicon compound may be appropriately selected.

It is preferable to appropriately adjust a heating temperature to be in a range of 50°C to 250°C. Moreover, a heating time is preferably in a range of 1 second to 10 hours.

As for irradiation with a vacuum ultraviolet ray, it is preferable that irradiation intensity and irradiation time be set in a range in which a base material to be irradiated is not damaged.

In the vacuum ultraviolet ray irradiation process, illuminance of the vacuum ultraviolet ray with which the polysilazane layer coating film is irradiated, on the coating film surface, is preferably 30 to 200 mW/cm$^2$, and more preferably 50 to 160 mW/cm$^2$. When the illuminance is in the above range, conversion efficiency is favorable and damage to be applied to the base material is reduced.

An irradiation energy amount of the vacuum ultraviolet ray on the surface of the polysilazane layer coating film is preferably 200 to 5,000 mJ/cm$^2$, and more preferably 500 to 3,000 mJ/cm$^2$. When the irradiation energy amount is in the above range, conversion efficiency is favorable and damage to be applied to the base material is reduced.

As a vacuum ultraviolet light source, a noble gas excimer lamp is preferably used. Since atoms of noble gas such as Xe, Kr, Ar, and Ne do not chemically bond to form molecules, the noble gas is called an inert gas. However, an excited atom of the noble gas that obtains energy from discharge or the like can form a molecule by bonding with another atom. When the noble gas is xenon, the following reaction occurs.

[Chem. 4]

$$e + Xe \rightarrow Xe^*$$

$$Xe^* + 2Xe \rightarrow Xe_2^* + Xe$$

$$Xe_2^* \rightarrow Xe + Xe + h\nu (172nm)$$

When $Xe_2^*$ that is an excited excimer molecule is transferred into a base state, excimer light of 172 nm is emitted.

As an example of characteristics of an excimer lamp, irradiation is concentrated on one wavelength and almost no light except for necessary light is radiated, thus being highly efficient. In addition, since excessive light is not radiated, a temperature of an object can be kept low. Furthermore, since a time for start-up and restart is not required, immediate lighting and blinking are possible.

In order to obtain excimer emission, a method of using a dielectric barrier discharge has been known. The dielectric barrier discharge is discharge called very thin micro discharge similar to lightning, which is generated in a gas space by arranging a gas space through a dielectric material such as transparent quartz between the both electrodes and applying a high-frequency high voltage at several tens kHz to the electrodes. When a streamer of micro discharge reaches a tube wall (derivative), charges are accumulated in the surface of the dielectric material and micro discharge thus disappears.

This micro discharge is discharge that spreads to the entire tube wall and repeats generation and disappearance. Therefore, light flickering recognizable with the naked eye is generated. In addition, since a streamer at a very high temperature locally and directly reaches the tube wall, there is a possibility to accelerate deterioration of the tube wall.

As a method of efficiently obtaining excimer light emission, electrodeless electric field discharge, other than the dielectric barrier discharge, may be also used. The electrodeless electric field discharge by capacitive coupling is also otherwise called RF discharge. Although a lamp, electrodes, and arrangement thereof may be basically the same as those in the dielectric barrier discharge, a high frequency to be applied between both electrodes illuminates at several of MHz. In the electrodeless electric field discharge, discharge uniform in terms of space and time is obtained as described above and thus a long-lasting lamp without flickering is obtained.

In the case of the dielectric barrier discharge, since micro discharge occurs only between the electrodes, the outside electrode has to cover the entire external surface and has to have a material, through which light passes, for taking out light to the outside, in order to perform discharge in the entire discharge space.

Therefore, the electrode in which thin metal wires are reticulated is used. Since wires which are as thin as possible are used so as not to block light, this electrode is easily damaged by ozone or the like generated by vacuum ultraviolet light in an oxygen atmosphere. For preventing this, it is necessary to make the periphery of the lamp, that is, the inside of an irradiation apparatus have an inert gas atmosphere such as nitrogen and to dispose a window with synthetic quartz to take out irradiation light. The window with synthetic quartz is not only an expensive expendable product but also causes the loss of light.

Since a double cylinder type lamp has an outer diameter of about 25 mm, a difference between distances to an irradiated surface just from under a lamp axis, and from the side surface of the lamp is not negligible to cause a big difference in illuminance. Accordingly, even if such lamps are closely arranged, no uniform illumination distribution is obtained. The irradiation apparatus provided with the window with synthetic quartz enables equal distances in an oxygen atmosphere and provides a uniform illumination distribution.

It is not necessary to reticulate an external electrode in a case where the electrodeless electric field discharge is used. Only by disposing the external electrode on a part of the external surface of the lamp, glow discharge spreads over the entire discharge space. For the external electrode, an electrode which serves as a light reflecting plate typically made of an aluminum block is used on the back surface of the lamp. However, since the outer diameter of the lamp is large as in the case of the dielectric barrier discharge, synthetic quartz is required for making a uniform illumination distribution.

The biggest feature of a narrow tube excimer lamp is a simple structure. Both ends of a quartz tube are only closed to seal a gas for excimer light emission therein.

The tube of the narrow tube lamp has an outer diameter of about 6 nm to 12 mm, and a high voltage is necessary for starting when the tube is too thick.

As discharge form, any of the dielectric barrier discharge and the electrodeless electric field discharge can be used. As for the shape of the electrode, a surface contacting with the lamp may be planar. However, when the shape is formed to be a shape fitting with the curved surface of the lamp, the lamp can be well fixed and the electrode is closely attached to the lamp to more stabilize discharge. Further, a light reflecting plate is also made when the curved surface is made to be a specular surface with aluminum. A preferred radiation source is an excimer radiator (for example, a Xe excimer lamp) having the maximum radiation at about 172 nm, a low-pressure mercury vapor lamp having an emission line at about 185 nm, medium-pressure and high-pressure mercury vapor lamps having a wavelength component of 230 nm or less, and an excimer lamp having the maximum radiation at about 222 nm.

Among them, a Xe excimer lamp is excellent in efficiency of light emission since an ultraviolet ray having a

short wavelength of 172 nm is radiated at a single wavelength. Since this light has a high oxygen absorption coefficient, the light enables a high concentration of a radical oxygen atomic species or ozone to be generated with a very small amount of oxygen. Further, the energy of light having a short wavelength of 172 nm is known to have a high capacity which dissociates the bond of organic material. Conversion of a polysilazane layer can be realized in a short time by the high energy of this active oxygen or ozone and ultraviolet radiation.

The excimer lamp can be made to illuminate by input of a low power because of having high light generation efficiency. Further, the excimer lamp does not emit light with a long wavelength which becomes a factor for increasing temperature due to light but emits light in an ultraviolet range, that is, irradiates energy with a short wavelength. Therefore, the excimer lamp has a feature of capable of suppressing increase in the surface temperature of an article to be irradiated. Accordingly, the excimer lamp is suitable for a flexible film material such as PET which is considered to be easily affected by heat.

Accordingly, shortening of process time and reduction in the area of a facility, due to a high throughput, and irradiation of an organic material, a plastic substrate, or the like, which is prone to suffer from damages caused by heat, are enabled in comparison with the low-pressure mercury vapor lamp which emits wavelengths of 185 nm and 254 nm and plasma cleaning.

Further, action of UV light not containing wavelength components of 180 nm or lower from the lowpressure mercury lamp emitting wavelengths of 185 nm and 254 nm (HgLP lamp) (185 nm and 254 nm) or a KrCl* excimer lamp (222 nm) is limited to direct photodegradation of the Si-N bond, that is, it does not generate an oxygen radical or a hydroxyl radical. In this case, as the absorption is a degree enough to be ignored, limitation regarding the concentration of oxygen and water vapor is not required. Another advantage of light with a shorter wavelength is that it has bigger depth of penetration into the polysilazane layer.

Oxygen is required for the reaction by ultraviolet ray irradiation. However, since the vacuum ultraviolet ray has absorption by oxygen, efficiency may be easily lowered during vacuum ultraviolet ray irradiation. Therefore, vacuum ultraviolet ray irradiation is preferably carried out in a state in which oxygen concentration and water vapor concentration are as low as possible. The oxygen concentration during the vacuum ultraviolet ray irradiation is preferably 10 to 210, 000 ppm by volume, more preferably 50 to 10,000 ppm by volume, and still more preferably 500 to 5,000 ppm by volume. Further, the water vapor concentration during the conversion process is preferably in a range of 1,000 to 4,000 ppm by volume.

A gas satisfying the irradiation atmosphere used for vacuum ultraviolet ray irradiation is preferably dry inert gas, and in particular, is preferably dry nitrogen gas from the viewpoint of cost. The adjustment of oxygen concentration can be achieved by changing flow rate ratio after measuring flow rate of oxygen gas and inert gas that are introduced to an irradiation cabin.

[Protective Layer]

In an embodiment, the gas barrier film may have a protective layer. The protective layer is generally disposed at the side of the second barrier layer opposite to the first barrier layer.

The protective layer contains, for example, polysiloxane and/or a product obtained by modifying polysiloxane.

(Polysiloxane)

The polysiloxane is not particularly limited, but well-known substances maybe used as the polysiloxane. Among them, organopolysiloxane represented by the following General Formula (2) is preferably used.

[Chem. 5]

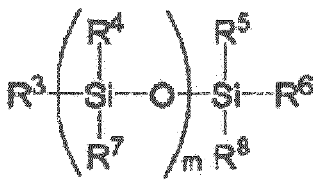

(2)

In the above General Formula (2), $R^3$ to $R^8$ each independently represent a C1 to C8 organic group. In this case, at least one of $R^3$ to $R^8$ is an alkoxy group or a hydroxyl group, and m is an integer of 1 or more. Examples of the C1 to C8 organic group include, although not particularly limited, a halogenated alkyl group such as a γ-chloropropyl

group or 3,3,3-trifluoropropyl group; an alkenyl group such as a vinyl group; an aryl group such as a phenyl group; a (meth)acrylic acid ester group such as a γ-methacryloxypropyl group; an epoxy-containing alkyl group such as a γ-glycidoxypropyl group; a mercapto-containing alkyl group such as a γ-mercaptopropyl group; an aminoalkyl group such as a γ-aminopropyl group; an isocyanate-containing alkyl group such as a γ-isocyanatepropyl group; a linear or branched alkyl group such as a methyl group, an ethyl group, a propyl group, or an isopropyl group; an alicyclic alkyl group such as a cyclohexyl group or a cyclopentyl group; a linear or branched alkoxy group such as a methoxy group, an ethoxy group, a propyloxy group, or an isopropyloxy group; and an acyl group such as an acetyl group, a propionyl group, a butyryl group, a valeryl group, or a caproyl group.

Of the organopolysiloxane represented by the above General Formula (2), it is more preferable to use organopolysiloxane in which m is 1 ormore and a weight average molecular weight (in terms of polystyrene) is 1,000 to 20,000. When the weight average molecular weight of organopolysiloxane is 1,000 or more, cracks hardly occur in the protective layer to be formed, and thus the gas barrier property can be maintained, which is favorable. Meanwhile, when the weight average molecular weight of organopolysiloxane is 20,000 or less, curing of the protective layer to be formed becomes sufficient, and thus sufficient hardness canbe obtained for the protective layer, which is favorable.

(Product Obtained by Modifying Polysiloxane)

The product obtained by modifying polysiloxane can be formed by modifying the above-described polysiloxane with vacuum ultraviolet light or the like. Specific compositions of the product obtained by modifying polysiloxane are not clearly known.

The protective layer may be a single layer or may be formed by laminating two or more layers. In a case where the protective layer is formed by laminating two or more layers, each layer may be formed of the same component or different components.

A thickness of the protective layer may be set appropriately according to a desired performance. For example, the thickness of the protective layer is preferably 100 nm to 10 μm, and more preferably 50 nm to 1 μm. When the thickness of the protect layer is 100 nm or more, sufficient barrier properties can be obtained, which is favorable. Meanwhile, when the thickness of the protective layer is 10 μm or less, it is possible to realize high light transmission properties and to stably perform coating at the time of forming the protective layer, which is favorable.

A film density of protective layer is generally 0.35 to 1.2 g/cm$^3$, preferably 0.4 to 1.1 g/cm$^3$, and more preferably 0.5 to 1.0 g/cm$^3$. When the film density is 0.35 g/cm$^3$ or more, it is possible to obtain sufficient mechanical strengthof the coating film, which is favorable. Meanwhile, when the film density is 1.2 g/cm$^3$ or less, cracks hardly occur in the protective layer, which is favorable.

(Formation of Protective Layer)

The protective layer can be formed by applying a coating liquid containing polysiloxane (polysiloxane coating liquid).

The polysiloxane coating liquid may further contain a solvent, or if necessary, a well-known component in addition to polysiloxane. Examples of the solvent include, although not particularly limited, water, an alcohol-based solvent, an aromatic hydrocarbon-based solvent, an ether-based solvent, a ketone-based solvent, an ester-based solvent, and the like. Examples of the alcohol-based solvent include methanol, ethanol, n-propyl alcohol, isopropyl alcohol, n-butyl alcohol, sec-butyl alcohol, tert-butyl alcohol, n-hexyl alcohol, n-octyl alcohol, ethyleneglycol, diethylene glycol, triethylene glycol, ethylene glycol monobutyl ether, ethylene glycol monoethyl ether acetate, diethylene glycol monoethyl ether, propylene glycol monomethyl ether, propylene monomethyl ether acetate, diacetone alcohol, methyl cellosolve, ethyl cellosolve, propyl cellosolve, butyl cellosolve, and the like. Examples of the aromatic hydrocarbon-based solvent include toluene, xylene, and the like. Examples of the ether-based solvent include tetrahydrofuran, 1,4-dioxane, 1,2-dimethoxyethane, and the like. Examples of the ketone-based solvent include cyclohexanone, acetone, methyl ethyl ketone, methyl isobutyl ketone, and the like. Examples of the ester-based solvent include methyl acetate, ethyl acetate, ethyoxyethyl acetate, and the like. In addition to these, a solvent such as dichloroethane or acetic acid may be used. These solvents may be used singly or by mixing two or more kinds thereof.

Further, examples of the well-known component which may be added other than a solvent include an amino silane compound, an epoxy silane compound, colloidal silica, and a curing catalyst.

As the coating method of the polysiloxane coating liquid, a well-known and appropriate wet coating method can be employed. Specifically, spin coating, dipping, roller blade coating, and spraying methods are exemplified.

A coated amount of the polysiloxane coating liquid is not particularly limited, but may be adjusted appropriately in consideration of the thickness of the gas barrier layer after drying.

After applying a polysiloxane coating liquid, it is preferable to dry a coating film. By drying the coating film, an organic solvent contained in the coating film can be removed. In this case, the whole organic solvent contained in the

coating film may be dried or some of the organic solvent may be allowed to remain. Even in the case of allowing some of the organic solvent to remain, a favorable protective layer may be obtained. As a drying method, it is possible to employ the same method as in the formation of the coating film in the above-described second barrier layer.

A layer obtained by performing the vacuum ultraviolet light irradiation on the coating film obtained in this manner and modifying polysiloxane may be used as a protective layer. The vacuum ultraviolet light irradiation is carried out by applying the same method as that of the vacuum ultraviolet light irradiation in the formation of the second barrier layer, and irradiation conditions may be appropriately set according to a desired performance. Incidentally, a specific composition of polysiloxane to be obtained by conversion is not clearly known.

[Intermediate Layer]

An intermediate layer may be provided between individual layers or on the surfaces of the film base material, the first barrier layer, the second barrier layer, and the protective layer described above within a range in which the effect of the present invention is not impaired.

For example, an intermediate layer such as an anchor coat layer, a smoothing layer, and a bleed-out preventing layer may be formed between layers of the film base material and the first barrier layer, or a surface of the film base material (filmbase material surface) opposite to the surface on which the first barrier layer is disposed.

(Anchor Coat Layer)

The anchor coat layer has functions of improving adhesiveness between the film base material and the gas barrier unit and providing high flatness. The anchor coat layer may be formed by, for example, applying an anchor coat agent onto a base material.

Examples of the anchor coat agent which can be used include, although not particularly limited, polyester resins, isocyanate resins, urethane resins, acrylic resins, ethylene vinyl alcohol resins, vinyl modified resins, epoxy resins, modified styrene resins, modified silicone resins, alkyl titanate, and the like. These anchor coat agents may be used singly or two or more kinds thereof may be used in combination. A well-known additive such as a solvent or a diluent may be further added to the anchor coat agent.

The coating method of the anchor coat agent onto the base material is not particularly limited, but examples thereof include roll coat, gravure coat, knife coat, dip coat, spray coat, and the like. The anchor coat layer may be formed by drying to remove a solvent or a diluent which may be included in the anchor coat agent coated onto the base material.

It is preferable to apply the anchor coat agent in a coated amount to be 0.1 to 5 $g/m^2$ in dried state.

(Smoothing layer)

A smoothing layer is generally formed on one surface of the film base material and has a function of preventing occurrence of unevenness or pinholes on the gas barrier unit or the like to be formed as a film on the film base material by smoothing a rough surface of the film base material on which minute protrusions and the like are present.

In the gas barrier film according to the present invention, in a case where the constituent material of the film base material described above includes polycarbonate (PC), it is preferable that the smoothing layer be provided between the film base material and the first barrier layer. This is because, when the smoothing layer is provided in a case where the constituent material of the film base material includes polycarbonate (PC), an advantage in which a dense and fragile gas barrier unit can be protected by the action of a PC base material having a relatively large water absorption rate and coefficient of thermal expansion isobtained. Further, from the viewpoint of little influence on the optical anisotropy of the film base material, it is preferable that the smoothing layer to be provided on the gas barrier film according to the present invention have no optical anisotropy. Incidentally, the expression "the smoothing layer has no optical anisotropy" means that refractive indexes in the in-plane direction and the film thickness direction of the smoothing layer itself do not have anisotropy.

The smoothing layer may be formed by, for example, applying a photosensitive resin composition onto a film base material, followed by curing.

The photosensitive resin composition generally includes a photosensitive resin, a photopolymerization initiator, and a solvent.

The photosensitive resin is not particularly limited as long as it is a photosensitive resin having a reactive monomer having one or more photopolymerizable unsaturated bonds in the molecule, but examples thereof include a resin containing an acrylate compound having a radical reactive unsaturated bond, a resin containing an acrylate compound and a mercapto compound having a thiol group, a resin containing a polyfunctional acrylate monomer such as epoxy acrylate, urethane acrylate, polyester acrylate, polyether acrylate, polyethylene glycol acrylate, or glycerol methacrylate, and the like. These resins may be used either singly or by mixing two or more kinds thereof.

Examples of the photopolymerization initiator include, although not particularly limited, acetophenone, benzophenone, Michler's ketone, benzoin, benzyl methyl ketal, benzoin benzoate, hydroxy cyclohexyl phenyl ketone, 2-methyl-1-(4-(methylthio)phenyl)-2-(4-morpholinyl)-1-p ropane, α-acyloxime ester, thioxanthones, and the like. These photopolymerization initiators may be used singly or two or more kinds thereof may be used in combination.

Examples of the solvent include, although not particularly limited, alcohols such as methanol, ethanol, propanol, isopropyl alcohol, ethyleneglycol, and propylene glycol; terpenes such as α- or β-terpineol; ketones such as acetone, methyl ethyl ketone, cyclohexanone, N-methyl-2-pyrrolidone, diethyl ketone, 2-heptanone, and 4-heptanone; aromatic hydrocarbons such as toluene, xylene, and tetramethyl benezene; glycol ethers such as cellosolve, methyl cellosolve, ethyl cellosolve, carbitol, methyl carbitol, ethyl carbitol, butylcarbitol, diethylene glycol dimethyl ether, diethylene glycol diethyl ether, diethylene glycol dipropyl ether, propylene glycol monomethyl ether, propylene glycol monoethyl ether, dipropylene glycol monomethyl ether, dipropylene glycol monoethyl ether, dipropylene glycol dimethyl ether, dipropylene glycol diethyl ether, dipropylene glycol dipropyl ether, triethylene glycol monomethyl ether, and triethylene glycol monoethyl ether; esters such as ethyl acetate, butyl acetate, cellosolve acetate, ethyl cellosolve acetate, butylcellosolve acetate, carbitol acetate, ethyl carbitol acetate, butylcarbitol acetate, propylene glycol monomethyl ether acetate, propylene glycol monoethyl ether acetate, 2-methoxyethyl acetate, cyclohexyl acetate, 2-ethyoxyethyl acetate, 3-methoxybutyl acetate, ethyl-3-ethoxypropionate, and methyl benzoate; and amides such as N,N-dimethylacetamide and N,N-dimethyl formamide. These solvent may be used either singly or by mixing two or more kinds thereof.

The photosensitive resin composition may be further added with an additive such as an oxidation inhibitor, an ultraviolet ray absorbing agent, a plasticizer, inorganic particles, or a resin other than a photosensitive resin, as necessary.

Among them, one of preferred additives is reactive silica particles on the surfaces of which photosensitive groups having photopolymerizable reactivity are introduced (hereinafter, also simply referred to as "reactive silica particles"). The photosensitive group having photopolymerizable reactivity is not particularly limited, but a polymerizable unsaturated group which is represented by a (meth) acryloyloxy group is exemplified. Adhesiveness with the gas barrier layer can be improved by reaction of the photosensitive group having photopolymerizable reactivity which the reactive silica particles have with the polymerizable unsaturated group which the photosensitive resin has.

The reactive silica particles are not particularly limited, but a substance obtained by generating silica particles and a silyloxy group by hydrolyzing a hydrolytic silyl group which hydrolyzable silane modified with a polymerizable unsaturated group has, that is, a substance in which silica particles are chemically bonded with hydrolyzable silane modified with a polymerizable unsaturated group maybe used as the reactive silica particles. Examples of the hydrolytic silyl group include, although not particularly limited, an alkoxy silyl group; a carboxylate silyl group such as an acetoxy silyl group; a halogenated silyl group such as a chloro silyl group; an amino silyl group; an oxime silyl group; and a hydrido silyl group. Further, examples of the polymerizable unsaturated group include, although not particularly limited, an acryloyloxy group, a methacryloyloxy group, a vinyl group, a propenyl group, a butadienyl group, a styryl group, an ethynyl group, a cinnamoyl group, a malate group, an acrylamide group, and the like.

An average particle diameter of the reactive silica particles, an average particle diameter is preferably 0.001 to 0.1 μm, and more preferably 0.001 to 0.01 μm. When the average particle diameter of the reactive silica particles is in the above range, an optical property in which an antiglare property and resolution are satisfied in a good balance, and a hard coat property may be obtained, by use in combination with a matting agent to be described below which may be contained photosensitive resin composition.

In a case where the reactive silica particles are contained in the photosensitive resin composition, the reactive silica particles are preferably contained in an amount of 20 to 60% by mass. When the reactive silica particles are contained in an amount of 20% by mass or more, adhesiveness with the gas barrier layer may be improved, which is favorable. Meanwhile, when the reactive silica particles are contained in an amount of 60% by mass or less, deformation of the film is suppressed under an environment of a high temperature and a high humidity and cracks occurred in accordance therewith may be suppressed, which is favorable.

Further, it is preferable that photosensitive resin composition include a matting agent. By containing a matting agent, it is possible to adjust an optical property.

Examples of the matting agent include, although not particularly limited, silica, alumina, talc, clay, calcium carbonate, magnesium carbonate, barium sulfate, aluminum hydroxide, titanium dioxide, zirconium oxide, and the like. The matting agent may be used singly or two or more kinds thereof may be used in combination.

An average particle diameter of the matting agent is preferably 0.1 to 10 μm, and more preferably 1 to 10 μm. When the average particle diameter of the matting agent is in the above range, an optical property in which an antiglare property and resolution are satisfied in a good balance, and a hard coat property may be obtained, by use in combination with the above-described reactive silica particles which may be contained in the photosensitive resin composition.

The content of the matting agent in the photosensitive resin composition is preferably 2 to 20 parts by mass, more preferably 4 to 18 parts by mass, and still more preferably 6 to 16 parts by mass with respect to 100 parts by mass of the solid content in the photosensitive resin composition.

Further, one of preferred additives which may be contained in the photosensitive resin composition is a resin

other than a photosensitive resin. Examples of the resin other than a photosensitive resin include, although not particularly limited, a thermoplastic resin, a thermosetting resin, and an ionizing radiation curable resin.

Specific examples of the thermoplastic resin include cellulose derivatives such as acetyl cellulose, nitrocellulose, acetyl butyl cellulose, ethyl cellulose, and methyl cellulose; vinyl-based resins such as vinyl acetate, vinyl chloride, vinylidene chloride, and copolymers thereof; acetal-based resins such as polyvinyl formal and polyvinyl butyral; acryl-based resins such as an acrylic resin, a methacrylic resin, and copolymers thereof; a polystyrene-based resin; a polyamide-based resin; a linear polyester-based resin; a polycarbonate-based resin; and the like.

Specific examples of the thermosetting resin include a thermosetting urethane resin formed of an acrylic polyol and an isocyanate prepolymer, a phenol resin, a urea melamine resin, an epoxy resin, an unsaturated polyester resin, a silicone resin, and the like.

As an specific example of the ionizing radiation curable resin, one which is cured by irradiating an ionizing radiation curable coating material prepared by mixing one or two or more of photopolymerizable prepolymers, photopolymerizable monomers, and the like with ionizing radiation (ultraviolet ray or electron beam) is exemplified. In this case, as the photopolymerizable prepolymer, an acryl-based prepolymer, which has two or more acryloyl groups in one molecule and is formed into a three-dimensional mesh structure by crosslinking-curing, such as urethane acrylate, polyester acrylate, epoxy acrylate, or melamine acrylate, is particularly preferable. Further, as the photopolymerizable monomer, the above-described photosensitive resin or the like may be used.

Examples of a method of coating a photosensitive resin composition onto a base material include, although not particularly limited, a wet coating method such as a spincoatingmethod, a spraying method, a blade coating method, or a dipping method, or a dry coating method such as a vapor deposition method. A smoothing layer may be formed in such a manner that a solvent or the like contained in the photosensitive resin composition coated onto the base material is removed by drying and then cured.

The curing is performed by using ionizing radiation. As for the ionizing radiation, it is possible to use vacuum ultraviolet light in a wavelength region of 100 to 400 nm, preferably 200 to 400 nm, emitted from an ultrahigh pressure mercury lamp, a high pressure mercury lamp, a low pressure mercury lamp, a carbon-arc lamp, a metal halide lamp, or the like; or electron beams in a wavelength region of 100 nm or less, emitted from a scanning-type or curtain-type electron beam accelerator.

The flatness of the smoothing layer is a value expressed by surface roughness specified by JIS B 0601 (2001), and a maximum cross-section height Rt(p) is preferably 10 to 30 nm. When Rt is 10 nm or more, in a case where a coating means such as a wire bar or a wireless bar is brought into contact with the surface of the smoothing layer in Step (2) of forming a coating film by applying a coating liquid containing polysilazane to be described later, stable coatability may be obtained, which is favorable. Meanwhile, when Rt is 30 nm or less, unevenness of the gas barrier layer to be obtained in Step to be described later may be smoothed, which is favorable.

A thickness of the smoothing layer is not particularly limited, but is preferably 1 to 10 μm, and more preferably 2 to 7 μm. When the thickness of the smoothing layer is 1 μm or more, it is possible to sufficiently exert a function as the smoothing layer, which is favorable. Meanwhile, when the thickness of the smoothing layer is 10 μm or less, it is possible to adjust the balance of optical properties of the gas barrier film and to suppress the curling of the gas barrier film, which is favorable.

(Bleed-out preventing layer)

The base material surface of the film base material having the smoothing layer may be contaminated due to the migration of an unreacted oligomer from the inside of the base material to the surface at the time of heating. The bleed-out preventing layer has a function of inhibiting the contamination of the surface of the film base material. The bleed-out preventing layer is generally provided at the side opposite to the smoothing layer of the base material having the smoothing layer.

The bleed-out preventing layer may have the same configuration as that of the smoothing layer if it has the above-described function. In other words, the bleed-out preventing layer may be formed by applying a photosensitive resin composition onto a base material and then curing.

Accordingly, a coating liquid is prepared by, for example, appropriately blending various components and adding a predetermined diluting solvent, and the coating liquid is applied onto the base material by a well-known coating method. Thereafter, the coating liquid is irradiated with ionizing radiation to be cured and thus the bleed-out preventing layer can be formed.

A thickness of the bleed-out preventing layer is preferably 1 to 10 μm, and more preferably 2 to 7 μm. When the thickness of the bleed-out preventing layer is 1 μm or more, heat resistance of the gas barrier film can be improved, which is favorable. Meanwhile, when the thickness of the bleed-out preventing layer is 10 μm or less, it is possible to appropriately adj ust optical properties of the gas barrier film and to suppress the curling of the gas barrier film, which is favorable.

In a case where at least one intermediate layer selected from the group consisting of the anchor coat layer, the smoothing layer, and the bleed-out preventing layer which are described above is formed on the film base material, the total film thickness of the film base material and the intermediate layer is preferably 5 to 500 μm, and more preferably 25 to 250 μm.

Further, an intermediate layer such as an overcoat layer may be further provided at the side (surface) opposite to the base material of the second barrier layer or protective layer.

(Overcoat Layer)

An overcoat layer may be formed by applying an organic resin composition coating liquid to form a coating film, followed by curing with a light irradiation treatment or a heat treatment. In general, the organic resin composition coating liquid includes a thermosetting resin and/or a photocurable resin, a photopolymerization initiator, and a solvent.

The thermosetting resin is not particularly limited as long as it is cured by the heat treatment, but examples thereof include phenol resin (PF), epoxy resin (EP), melamine resin (MF), urea resin (UF), unsaturated polyester resin (UP), alkyd resin, polyurethane (PUR), thermosetting polyimide (PI), and the like.

The photocurable resin is not particularly limited as long as it is cured by the light treatment, but examples thereof include a resin containing an acrylate compound having a radical reactive unsaturated bond, a resin containing an acrylate compound and a mercapto compound having a thiol group, a resin containing a polyfunctional acrylate monomer such as epoxy acrylate, urethane acrylate, polyester acrylate, polyether acrylate, polyethylene glycol acrylate, or glycerol methacrylate, "ORMOCER" described in US Patent No. 6,503,634, and the like. In addition, amonomer having one or more of photopolymerizable unsaturated groups in the molecule may be used. Examples of the monomer include methyl acrylate, ethyl acrylate, n-propyl acrylate, isopropyl acrylate, n-butyl acrylate, isobutyl acrylate, tert-butyl acrylate, n-pentyl acrylate, n-hexyl acrylate, 2-ethylhexyl acrylate, n-octyl acrylate, n-decyl acrylate, hydroxyethyl acrylate, hydroxypropyl acrylate, allyl acrylate, benzyl acrylate, butoxyethyl acrylate, butoxyethylene glycol acrylate, cyclohexyl acrylate, dicyclopentanyl acrylate, 2-ethylhexyl acrylate, glycerol acrylate, glycidyl acrylate, 2-hydroxyethyl acrylate, 2-hydroxypropyl acrylate, isobornyl acrylate, isodexyl acrylate, isooctyl acrylate, lauryl acrylate, 2-methoxyethyl acrylate, methoxyethylene glycol acrylate, phenoxyethyl acrylate, stearyl acrylate, ethylene glycol diacrylate, diethylene glycol diacrylate, 1,4-butanediol diacrylate, 1,5-pentanediol diacrylate, 1,6-hexadiol diacrylate, 1,3-propanediol acrylate, 1,4-cyclohexanediol diacrylate, 2,2-dimethylolpropane diacrylate, glycerol diacrylate, tripropylene glycol diacrylate, glycerol triacrylate, trimethylolpropane triacrylate, polyoxyethyl trimethylolpropane triacrylate, pentaerythritol triacrylate, pentaerythritol tetraacrylate, ethylene oxide modified pentaerythritol triacrylate, ethylene oxide modified pentaerythritol tetraacrylate, propione oxide modified pentaerythritol triacrylate, propione oxide modified pentaerythritol tetra acrylate, triethylene glycol diacrylate, polyoxypropyl trimethylolpropane triacrylate, butyleneglycol diacrylate, 1,2,4-butanediol triacrylate, 2,2,4-trimethyl-1,3-pentadiol diacrylate, diallyl fumarate, 1,10-decanedioldimethyl acrylate, pentaerythritol hexaacrylate, and those in which the above acrylates are converted with methacrylates, γ-methacryloxypropyl trimethoxysilane, 1-vinyl-2-pyrrolidone, and the like.

It is preferable that the thermosetting resin and/or the photocurable resin include a polymerizable group and/or a crosslinkable group. The polymerizable group and the crosslinkable group are not particularly limited as long as polymerization reaction or cross-linking reaction occurs by the light irradiation or heat treatment, but examples thereof include well-known functional groups. Specific examples thereof include a polymerizable group such as an ethylenically unsaturated group, or a cyclic ether group of an epoxy group, an oxetanyl group, or the like; a crosslinking group such as a thiol group, a halogen atom, or an onium salt structure; and the like. Among these, it is preferable to have an ethylenically unsaturated group, and as the ethylenically unsaturated group, functional groups described in Japanese Patent Application Laid-Open No. 2007-17948 are exemplified.

The thermosetting resin and/or the photocurable resin may be used either singly or by mixing two or more kinds thereof.

Examples of the photopolymerization initiator include, although not particularly limited, benzophenone, o-benzoylmethyl benzoate, 4,4-bis(dimethylamine)benzophenone, 4,4-bis(diethylamine)benzophenone, α-amino-acetophenone, 4,4-dichlorobenzophenone, 4-benzoyl-4-methyl diphenyl ketone, dibenzyl ketone, fluorenone, 2,2-diethoxyacetophenone, 2,2-dimethoxy-2-phenylacetophenone, 2-hydroxy-2-methylpropiophenone, p-tert-butyl dichloroacetophenone, thioxanthone, 2-methylthioxanthone, 2-chlorothioxanthone, 2-isopropyl thioxanthone, diethylthioxanthone, benzyldimethyl ketal, benzylmethoxyethyl acetal, benzoinmethyl ether, benzoinbutyl ether, anthraquinone, 2-tert-butylanthraquinone, 2-amylanthraquinone, β-chloranthraquinone, anthrone, benzanthrone, dibenzosuberone, methyleneanthrone, 4-azidobenzylacetophenone, 2,6-bis(p-azidobenzylidene)cyclohexane, 2,6-bis(p-azidobenzylidene)-4-methylcyclohexanone, 2-phenyl-1,2-butadione-2-(o-methoxycarbonyl)oxime, 1-phenyl-propanedione-2-(o-ethoxycarbonyl)oxime, 1,3-diphenyl-propanetrione-2-(o-ethoxycarbonyl)oxime, 1-phenyl-3-ethoxy-propanetrione-2-(o-benzoyl)oxime, Michler's ketone, 2-methyl[4-(methylthio)phenyl]-2-morpholino-1-propane, 2-benzyl-2-dimethylamino-1-(4-morpholinophenyl)-butanon e-1, naphthalenesulfonyl chloride, quinolinesulfonyl chloride, n-phenylthioacridone, 4,4-azobisisobutylonitrile, diphenyl disulfide, benzothiazol disulfide, triphenylphosphine, camphorquinone, carbon tetrabromide, tribromophenyl sulfone, benzoine peroxide, eosin, combinations of photoreducing pigments such as methylene blue and reducing agents (ascorbic acid, triethanol amine, or the like), and the like. These photopolymerization initiators may be either used singly or by mixing two or more kinds thereof.

Examples of the solvent include, although not particularly limited, alcohols such as methanol, ethanol, propanol, isopropyl alcohol, ethylene glycol, and propylene glycol; terpenes such as α- or β-terpineol; ketones such as acetone, methyl ethyl ketone, cyclohexanone, N-methyl-2-pyrrolidone, diethyl ketone, 2-heptanone, and 4-heptanone; aromatic hydrocarbons such as toluene, xylene, and tetramethyl benezene; glycol ethers such as cellosolve, methyl cellosolve, ethyl cellosolve, carbitol, methyl carbitol, ethyl carbitol, butyl carbitol, diethylene glycol dimethyl ether, diethylene glycoldiethyl ether, diethylene glycol dipropyl ether, propylene glycol monomethyl ether, propylene glycol monoethyl ether, dipropylene glycol monomethyl ether, dipropylene glycol monoethyl ether, dipropylene glycoldimethyl ether, dipropylene glycoldiethyl ether, dipropylene glycol dipropyl ether, triethylene glycol monomethyl ether, and triethylene glycol monoethyl ether; esters such as ethyl acetate, butyl acetate, cellosolve acetate, ethyl cellosolve acetate, butylcellosolve acetate, carbitol acetate, ethyl carbitol acetate, butyl carbitol acetate, propylene glycol monomethyl ether acetate, propylene glycol monoethyl ether acetate, 2-methoxyethyl acetate, cyclohexyl acetate, 2-ethyoxyethyl acetate, 3-methoxybutyl acetate, ethyl-3-ethoxy propionate, and methyl benzoate; and amides such as N,N-dimethylacetamide and N,N-dimethyl formamide. These solvent may be used either singly or by mixing two or more kinds thereof.

An additive such as an oxidation inhibitor, an ultraviolet ray absorbing agent, a plasticizer, inorganic particles, a coupling agent, or a resin other than a photosensitive resin may be further added in the organic resin composition coating liquid, as necessary.

Among them, a preferred additive is inorganic particles and a coupling agent.

By adding inorganic particles, it is possible to adjust the elastic modulus of the overcoat layer. Examples of the inorganic particles include, although not particularly limited, $SiO_2$, $Al_2O_3$, $TiO_2$, $ZrO_2$, ZnO, $SnO_2$, $In_2O_3$, BaO, SrO, CaO, MgO, $VO_2$, $V_2O_5$, $CrO_2$, $MoO_2$, $MoO_3$, $MnO_2$, $Mn_2O_3$, $WO_3$, $LiMn_2O_4$, $Cd_2SnO4$, $CdIn_2O_4$, $Zn_2SnO_4$, $ZnSnO_3$, $Zn_2In_2O_5$, $Cd_2SnO_4$, $CdIn_2O_4$, $Zn_2SnO_4$, $ZnSnO_3$, $Zn_2In_2O_5$, and the like. In addition, as the inorganic particles, it is possible to use plate-shaped particles such as mica (for example, natural mica or synthetic mica), talc represented by a formula of $3MgO{\cdot}4SiO{\cdot}H_2O$, teniolite, montmorillonite, saponite, hectorite, synthetic smectite, and zirconium phosphate. Examples of the natural mica include white mica, soda mica, brown mica, black mica, lepidolite, and the like. Further, examples of the synthetic mica include nonswelling mica such as fluoride brown mica $KMg_3(AlSi_3O_{10})F_2$ or potassium tetrasilicic mica $KMg_{2.5}$ $(Si_4O_{10})$ $F_2$; swelling mica such as Na tetrasilylic mica $NaMg_{2.5}$ $(Si_4O_{10})$ $F_2$, Na or Li teniolite $(Na, Li)Mg_2Li(Si_4O_{10})F_2$, or montmorillonite-based Na or Li hectorite $(Na, Li)_{1/8}Mg_{2/5}Li_{1/8}(Si_4O_{10})F_2$; and the like. These inorganic particles may be used either singly or by mixing two or more kinds thereof.

A number average particle diameter of inorganic particles is preferably 1 to 200 nm, and more preferably 3 to 100 nm.

As the inorganic particles, surface-treated inorganic particles may be used. It is possible to personally prepare inorganic particles according to methods described in recent scientific papers, but commercially available inorganic particles may be also used. Examples of the commercially available inorganic particles include Snowtex series and Organosilica sol (produced by Nissan Chemical Industries, Ltd.), NANOBYK series (produced by BYK Japan KK), NanoDur (produced by Nanophase Technologies Corporation), and the like.

The content of inorganic particles in the overcoat layer is preferably 10 to 95% by mass, and more preferably 20 to 90% by mass with respect to the mass of the overcoat layer.

Further, by adding a coupling agent in the overcoat layer, it is possible to mix other materials. Examples of the coupling agent include, although not particularly limited, a silane coupling agent, a titanate-based coupling agent, an aluminate-based coupling agent, and the like. Among them, a silane coupling agent is preferably used from the viewpoint of the stability of a coating liquid.

Examples of the silane coupling agent include a halogen-containing silane coupling agent such as 2-chloroethyltrimethoxysilane, 2-chloroethyltriethoxysilane, 3-chloropropyltrimethoxysilane, or 3-chloropropyltriethoxysilane; an epoxy group-containing silane coupling agent such as 2-(3,4-epoxycyclohexyl)ethyltrimethoxysilane, 2-(3,4-epoxycyclohexyl)ethyltriethoxysilane, 3-(3,4-epoxycyclohexyl)propyltrimethoxysilane, 2-glycidyloxyethyltrimethoxysilane, 2-glycidyloxyethyltriethoxysilane, 3-glycidyloxypropyltrimethoxysilane, or 3-glycidyloxypropyltriethoxysilane; an amino group-containing silane coupling agent such as 2-aminoethyltrimethoxysilane, 3-aminopropyltrimethoxysilane, 3-aminopropyltriethoxysilane, 2-[N-(2-aminoethyl)amino]ethyltrimethoxysilane, 3-[N-(2-aminoethyl)amino]propyltrimethoxysilane, 3-(2-aminoethyl)amino]propyltriethoxysilane, or 3-[N-(2-aminoethyl)amino]propylmethyl dimethoxysilane; a mercapto group-containing silane coupling agent such as 2-mercaptoethyltrimethoxysilane, 3-mercaptopropyltrimethoxysilane, or 3-mercaptopropyltriethoxysilane; a vinyl group-containing silane coupling agent such as vinyltrimethoxysilane or vinyltriethoxysilane; a (meth)acryloyl group-containing silane coupling agent such as 2-methacryloyloxyethyltrimethoxysilane, 2-methacryloyloxyethyltriethoxysilane, 2-acryloyloxyethyltrimethoxysilane, 3-methacryloyloxypropyltrimethoxysilane, 3-methacryloyloxypropyltriethoxysilane, or 3-acryloyloxypropyltrimethoxysilane; and the like. The silane coupling agent may be used either singly or in combination with two or more kinds thereof.

The method of coating an organic resin composition coating liquid is not particularly limited, but a wet coating method such as a spin coating method, a spraying method, a blade coating method, or a dipping method, or a dry coating method such as a vapor deposition method is preferably used. An overcoat layer may be formed in such a manner that a solvent or the like contained in the coated organic resin composition coating liquid is removed by drying and then cured.

In the case of using a thermosetting resin as an organic resin, the curing is generally performed by heating. A heating temperature also varies depending on a thermosetting resin to be used, but the heating temperature is preferably 50 to 150°C. Meanwhile, in the case of using a photocurable resin as an organic resin, the curing is generally performed by ionizing radiation. As for the ionizing radiation, it is possible to use vacuum ultraviolet light in a wavelength region of 100 to 400 nm, preferably 200 to 400 nm, emitted from an ultrahigh pressure mercury lamp, a high pressure mercury lamp, a low pressure mercury lamp, a carbon-arc lamp, a metal halide lamp, or the like; or electron beams in a wavelength region of 100 nm or less, emitted from a scanning-type or curtain-type electron beam accelerator. The light irradiation may be performed by vacuum ultraviolet light irradiation. When a hard-coat layer is formed by vacuum ultraviolet light, the second gas barrier layer and overcoat layer can be formed by applying at the same line.

[Linear Polarizing Plate (Polarizer)]

In the gas barrier film according to the present invention, as illustrated in Fig. 1, a linear polarizing plate (polarizer) maybe further disposed at the side opposite to the gas barrier unit of the film base material.

The linear polarizing plate (polarizer) is an element which transmits polarized light in only a predetermined direction. Therefore, by having a configuration as described above, in a case where the film base material is a $\lambda/4$ phase difference plate, the linear polarizing plate (polarizer) and the film base material ($\lambda/4$ phase difference plate) constitute a circular polarizing plate. Due to the phase difference of the circular polarizing plate, internal reflection light of various interfaces or metal electrode present in the inside of the light emitting element can be confined in the inside of the circular polarizing plate. As a result, the gas barrier film according to the present invention is used as a sealing film of various display elements at the view side, the gas barrier unit is disposed at the display element (cell) side, and the circular polarizing plate is disposed at the view side. According to this, a decrease in display contrast due to internal reflection light can be suppressed.

More specifically, outside light, which enters from the view-side surface, passes a transmission axis of the linear polarizing plate (polarizer), and thereby is linearly polarized in only one direction. This linearly polarized light passes the $\lambda/4$ phase difference plate, and is converted into circularly polarized light. Further, the light is reflected at the interface or metal electrode in the display element to pass the $\lambda/4$ phase difference plate again, and thus returns to linearly polarized light. In this case, the phase difference of the reflected light in the display element is deviated by $\lambda/2$ from the linearly polarized light when entering, and thereby the light becomes linearly polarized light having a 90° different angle. Accordingly, the light is absorbed by the absorption axis of the linear polarizing plate (polarizer) and the reflected light is prevented from outputting to the outside. Incidentally, in order to achieve this object, it is preferable that the absorption axis of the linear polarizing plate (polarizer) and the phase retardation axis of the film base material ($\lambda/4$ phase difference plate) be disposed such that the angle therebetween is within 45° $\pm$ 5°, and particularly within 45° $\pm$ 1°.

The representative polarizer, which is presently known, is a polyvinyl alcohol type polarizing film, which includes a polyvinyl alcohol type film dyed with iodine and a polyvinyl alcohol type film dyed with dichroic dyes.

As a polarizer, it is possible to use one in which a film is prepared using an aqueous polyvinyl alcohol solution and the resulting film is uniaxially stretched and dyed, or is uniaxially stretched after having been dyed, preferably followed by being subjected to a durability treatment with a boron compound. The film thickness of the polarizer is preferably 5 to 30 $\mu$m, and particularly preferably 10 to 20 $\mu$m.

Further, ethylene modified polyvinyl alcohol, which is described in Japanese Patent Application Laid-Open No. 2003-248123, Japanese Patent Application Laid-Open No. 2003-342322, or the like and has an ethylene unit content of 1 to 4 mol%, a polymerization degree of 2,000 to 4,000 and a saponification degree of 99.0 to 99.99 mol%, is also preferably used. Of these, an ethylene modified polyvinyl alcohol film having a hot water breaking temperature of 66 to 73°C is preferably used. A polarizer using this ethylene modified polyvinyl alcohol film is excellent in polarization performance and durability performance, as well as exhibits few color spottiness, and thus is particularly preferably used in various display elements.

Furthermore, in the present invention, as a linear polarizing plate (polarizer), it is possible to use not only an absorption-type polarizing plate, which is obtained by stretching a polymer film dyed with a dye, but also a reflection-type polarizing plate, which is obtained by alternately laminating plural phase difference films so that their phase retardation axial directions perpendicularly intersect. In such a reflection-type polarizing plate, for one polarized light, the refractive indexes of the respective layers are substantially the same, and thereby reflection of incident light does not occur at the interface between the respective layers. For the other polarized light, the refractive indexes of the respective layers differ, and thereby incident light can be reflected and returned at the interface of the phase difference film.

Alternatively, it is also possible to use a wire grid-type polarizing plate, which is obtained by continuously arranging fine metal wires having a smaller width than the wavelength size on a film, as a linear polarizing plate (polarizer) in the present invention.

[Other Layers (Polymer Film and the like)]

In the gas barrier film according to the present invention, layers other than the above-described various layers (for example, layers formed by various polymer films or the like) may be further arranged.

In this case, a laminate of every layer including a film base material except the above-described linear polarizing plate (polarizer) is preferably configured such that an in-plane phase difference (Ro) is $\lambda/4$ with respect to light having a wavelength of 550 nm. As an example having such a configuration, an embodiment in which a film base material is configured such that an in-plane phase difference (Ro) is $\lambda/4$ with respect to light having a wavelength of 550 nm and all of the other layers have no optical anisotropy is exemplified. Here, the light having a wavelength of 550 nm is light which has highest visibility. Therefore, by employing such a configuration, internal reflection can be suppressed most effectively. Note that, similarly to the above description, the phase difference of the laminate of every layer including a film base material except the linear polarizing plate (polarizer) is preferably approximately $\lambda/4$ (Ro = 148 $\pm$ 10 nm) with respect to not only the light having a wavelength of 550 nm but also light having other wavelengths of the visible light region. A general polymer film has positive wavelength dispersibility in which a phase difference becomes larger with respect to light having a shorter wavelength so that it is difficult to make the total phase difference of all layers approximately $\lambda/4$ over the visible light region as a whole. However, by using a polymer film having wavelength dispersibility in which a phase difference becomes smaller with respect to light having a shorter wavelength (that is, reverse wavelength dispersibility) as disclosed in Japanese Patent Application Laid-Open No. 2000-137116, it is possible to make the total phase difference of all layers approximately $\lambda/4$ over the visible light region as a whole.

«Applications of Gas Barrier Film»

The gas barrier film according to the present invention is applicable mainly for package of electronic devices and the like, or for gas barrier films used for display materials such as an organic EL element, a solar cell, and a plastic substrate of a crystal display element and the like, and for various substrates for an electronic device using a gas barrier film and various electronic devices. In addition, the gas barrier film according to the present invention is preferably applicable for various sealing materials and sealing films. In this case, since the film base material forming the gas barrier film according to the present invention has optical anisotropy, the gas barrier film according to the present invention is preferably disposed at least on a view side (display side) of the display element and used. Further, it is a preferred embodiment that a view-side (display-side) substrate of the display element is configured as described later. Note that, even when being not usedas a substrate, after temporarily sealing the display element, the gas barrier film according to the present invention may be attached so as to be disposed at the view side (display side) and thus the entire element may be sealed.

Hereinafter, an organic EL element is exemplified as a specific electronic device and the configuration thereof will be described in detail.

(Organic EL Element)

The organic EL element is not particularly limited, but, generally, may have the following layer structure.

(1) anode/light emitting layer/cathode,
(2) anode/hole transport layer/light emitting layer/cathode,
(3) anode/light emitting layer/electron transport layer/cathode,
(4) anode/hole transport layer/light emitting layer/electron transport layer/cathode, or
(5) anode/anode buffer layer (hole injection layer)/hole transport layer/light emitting layer/electron transport layer/cathode buffer layer (electron injection layer)/cathode.

(Anode)

As an anode, although not particularly limited, it is preferable to use a metal, an alloy, a conductive compound, which is provided with a large work function (4 eV or more), and a mixture thereof. Specific examples thereof include a conductive transparent material such as metal like gold (Au), copper iodide (CuI), indium tin oxide (ITO), tin oxide ($SnO_2$) and zinc oxide (ZnO). Further, a material such as IDIXO ($In_2O_3$-ZnO), which can prepare an amorphous and transparent conductive film, may be also used.

As for an anode, these electrode substances may be made into a thin layer by a method such as evaporation or sputtering. At this time, a pattern formation may be carried out by a photolithography method. In a case where high pattern precision (about 100 μm or more) is not required, a pattern may be formed by evaporation or sputtering using a mask.
When emission is extracted from the above-described anode, the transmittance is preferably set to 10% or more. Further, the sheet resistance of the anode is preferably hundreds Ω/□ (square) or less. Furthermore, although the film thickness of the anode depends on a material, it is generally selected in a range of 10 to 1,000 nm and preferably of 10 to 200 nm.

(Cathode)

As a cathode, although not particularly limited, it is preferable to use a metal (hereinafter, referred to as an "electron injection metal"), an alloy, a conductive compound and a mixture thereof, which have a small work function (4 eV or less). Specific examples thereof include sodium, a sodium-potassium alloy, magnesium, lithium, a magnesium/copper mixture, a magnesium/silver mixture, a magnesium/aluminum mixture, a magnesium/indium mixture, an aluminum/aluminum oxide ($Al_2O_3$) mixture, indium, a lithium/aluminum mixture, rare earth metal, and like. Among them, from the viewpoint of an electron injection property and durability against oxidation or the like, it ispreferable to use a mixture of electron injecting metal with a metal which is stable metal having a work function larger than the electron injecting metal, such as a magnesium/silver mixture, a magnesium/aluminum mixture, a magnesium/indium mixture, an aluminum/aluminum oxide ($Al_2O_3$) mixture, and a lithium/aluminum mixture.
As for a cathode, these electrode substances may be formed into a thin layer by a method such as evaporation or sputtering.
The sheet resistance of the cathode is preferably hundreds Ω/□ or less. The film thickness of the cathode is generally in a range of 1 nm to 5 μm and preferably of 50 to 200 nm.
Incidentally, in order to obtain excellent emission luminance by transmitting emitted light, either one of the anode or the cathode is preferably transparent or translucent. Further, after preparing a cathode formed by using metal or the like, which may be used as the above-described cathode, to have a film thickness of 1 to 20 nm, a conductive transparent material, which may be used as the above-described anode, is prepared on the prepared cathode, whereby a transparent or translucent cathode may be prepared. By employing this, it is possible to prepare an element in which both of the anode and the cathode exhibit transmitting properties.
Incidentally, according to another embodiment of the present invention, there is also provided a substrate for an electronic device obtained by forming a transparent electrode (anode or cathode). Specifically, as illustrated in Fig. 1, the substrate for an electronic device can be configured by disposing a transparent electrode at the side of the gas barrier unit forming the gas barrier film of the present invention, which is opposite to the filmbase material, the gas barrier film having a linear polarizing plate (polarizer) disposed thereon and a function as a circular polarizing plate.
The substrate for an electronic device having such a configuration has a function as a circular polarizing plate together with a function as a gas barrier film. Further, in a case where the substrate is used for the purpose of causing the circular polarizing plate to exhibit a function of preventing internal reflection in the display element, it is most preferable to use the substrate as at least a view-side (display-side) substrate of the display element.

(Injection Layer: Electron Injection Layer and Hole Injection Layer)

An injection layer includes an electron injection layer (cathode buffer layer) and a hole injection layer (anode buffer layer). The electron injection layer and the hole injection layer are provided as necessary, and are arranged between an anode and a light emitting layer or a hole transport layer, and/or between a cathode and a light emitting layer or an electron transport layer.
The injection layer is a layer which is arranged between an electrode and an organic layer to decrease an operating voltage and to improve an emission luminance, which is detailed in volume 2, chapter 2 "Electrode Materials" (pp. 123 to 166) of "Organic ELElements and Industrialization Front thereof (November 30, 1998, published by N. T. S Corp.)"
The hole injection layer (anode buffer layer) is also detailed in Japanese Patent Application Laid-Open No. 9-45479, Japanese Patent Application Laid-Open No.9-260062, Japanese Patent Application Laid-Open No. 8-288069, and the like. Specific examples thereof include a phthalocyanine buffer layer as represented by copper phthalocyanine, an oxide buffer layer as represented by vanadium oxide, an amorphous carbon buffer layer, a polymer buffer layer using a conductive polymer such as polyaniline (emeraldine) or polythiophene.
The electron injection layer (cathode buffer layer) is also detailed in Japanese Patent Application Laid-Open No. 6-325871, Japanese Patent Application Laid-Open No. 9-17574, Japanese Patent Application Laid-Open No. 10-74586, and the like. Specific examples thereof include a metal buffer layer as represented by strontium, aluminum,

or the like, an alkali metal compound buffer layer as represented by lithium fluoride, an alkali earthmetal compound buffer layer as represented by magnesium fluoride, an oxide buffer layer as represented by aluminum oxide, and the like.

The injection layer (buffer layer) is preferably a very thin film, and the film thickness is preferably in a range of 0.1 nm to 5 μm although it depends on a raw material.

(Light Emitting Layer)

The light emitting layer is a layer, which emits light via recombination of electrons and holes injected from an electrode (cathode, anode), or an electron transport layer or a hole transport layer. The light emission portion may be present either within the light emitting layer or at the interface between the light emitting layer and an adjacent layer thereof.

As the light emitting layer, there are a blue light emitting layer, a green light emitting layer, and a red light emitting layer. When the light emitting layers are laminated, a non-light emitting intermediate layer may be provided between the light emitting layers without limitation of the lamination order thereof. In this embodiment, it is preferable that the blue light emitting layer be provided at a position nearest to an anode among all light emitting layers. When four or more of light emitting layers are provided, from the viewpoint of increasing brightness stability, it is preferable to laminate, from the order near to the anode, the blue light emitting layer, the green light emitting layer, and the red light emitting layer in this order, for example, the blue light emitting layer/the green light emitting layer/the red light emitting layer/the blue light emitting layer, the blue light emitting layer/the green light emitting layer/the red light emitting layer/the blue light emitting layer/the green light emitting layer, or the blue light emitting layer/the green light emitting layer/the red light emitting layer/the blue light emitting layer/the green light emitting layer/the red light emitting layer. By making the light emitting layer be multilayered, it is possible to prepare a white element.

Materials which constitute the light emitting layer are not particularly limited as long as they are organic light emitting materials which have (a) a charge injection function (function capable of injecting a hole from an anode or a hole injection layer, and injecting an electron form a cathode or an electron injection layer during electric field application), (b) a transport function (function of moving the injected electron and hole by electric field power), and (c) a light emitting function (function of providing recombination of injected electron and hole and leading them to emit light) together. Examples of the organic light emitting materials include a benzoxazole-based fluorescent whitening agent, a benzothiazole-based fluorescent whitening agent, a benzimidazole-based fluorescent whitening agent, and a styrylbenezene-based compound.

Examples of the benzoxazole-based fluorescent whitening agent include 2,5-bis(5,7-di-t-pentyl-2-benzoxazolyl)-1,3,4-thiadiazo le, 4,4'-bis(5,7-t-pentyl-2-benzoxazolyl)stylbene, 4,4'-bis[5,7-di-(2-methyl-2-butyl)-2-benzoxazolyl]stylb ene, 2,5-bis(5,7-di-t-pentyl-2-benzoxazolyl)thiophene, 2,5-bis[5-α,α-dimethylbenzyl-2-benzoxazolyl]thiophene, 2,5-bis[5,7-di-(2-methyl-2-butyl)-2-benzoxazolyl]-3,4-d iphenylthiophene, 2,5-bis(5-methyl-2-benzoxazolyl)thiophene, 4,4'-bis(2-benzoxazolyl)biphenyl, 5-methyl-2-[2-[4-(5-methyl-2-benzoxazolyl)phenyl]vinyl] benzoxazole, 2-[2-(4-chlorophenyl)vinyl]naphtho[1,2-d]oxazole, and the like.

Examples of the benzothiazole-based fluorescent whitening agent include 2,2'-(p-phenylenedivinylene)-bisbenzothiazole and the like.

Examples of the benzimidazole-based fluorescent whitening agent include 2-[2-[4-(2-benzimidazolyl)phenyl]vinyl]benzimidazole, 2-[2-(4-carboxyphenyl)vinyl]benzimidazole, and the like.

Examples of the styrylbenezene-based compound include 1,4-bis(2-methylstyryl)benezene, 1,4-bis(3-methylstyryl)benezene, 1,4-bis(4-methylstyryl)benezene, distyrylbenezene, 1,4-bis(2-ethylstyryl)benezene, 1,4-bis(3-methylstyryl)benezene, 1,4-bis(2-methylstyryl)-2-methylbenezene, 1,4-bis(2-methylstyryl)-2-ethylbenezene, and the like.

In addition to these, it is possible to use 12-phthaloperynone, 1,4-diphenyl-1,3-butadiene, 1,1,4,4-tetraphenyl-1,3-butadiene, a naphthalimide derivative, a perylene derivative, an oxydiazole derivative, an aldazine derivative, a pyrazoline derivative, a cyclopentadiene derivative, a pyrrolopyrrole derivative, a styrylamine derivative, a coumalin-based compound, and an aromatic dimethylidyne-based compound; and polymer compounds described in Chemistry of Synthetic Dyes (1971), pages 628 to 637 and 640, International Publication No. WO 90/13148, and Appl. Phys. Lett., vol 58, 18, P1982 (1991).

Examples of the aromatic dimethylidyne-based compound include 1,4-phenylenedimethylidene, 4,4'-phenylenedimethylidene, 2,5-xylylenedimethylidene, 2,6-naphthylenedimethylidene, 1,4-biphenylenedimethylidene, 1,4-p-terephenylenedimethylidene, 4,4'-bis(2,2-di-t-butylphenylvinyl)biphenyl, 4,4'-bis(2,2-diphenylvinyl)biphenyl, and their derivatives.

In addition to the above, it is also preferable to use, as an organic light emitting material, a compound obtained by using the above-described organic light emitting material as a host and then doping the host with strong blue to green fluorescent dyes (coumarin-based dye or the like), and a compound doped with the same fluorescent dye as in the host. In a case where the above-described compounds are used as an organic light emitting material, it is possible to highly efficiently obtain blue to green light emission (colors of light emission are different depending on the type of dopants). Specific examples of the host which is a material of the above-described compound include organic light emitting materials

having a distyrylarylene skeleton (particularly preferably, for example, 4,4'-bis(2,2-diphenylvinyl)biphenyl). Specific examples of the dopant which is a material of the above-described compound include diphenylaminovinyl arylene (particularly preferably, for example, N,N-diphenylamino biphenyl benezene or 4,4'-bis[2-[4-(N,N-di-p-tolyl)phenyl]vinyl]biphenyl).

It is preferable that a well-known host compound and a well-known phosphorescent compound (also referred to as a phosphorescent emission compound) be contained in the light emitting layer in order to improve efficiency of light emission of the light emitting layer.

A host compound is defined as a compound featuring a mass ratio of 20% or more in a light emitting layer based on all the compounds incorporated therein and exhibiting a phosphorescence quantum yield of less than 0.1 in terms of phosphorescence emission at room temperature (25°C). The phosphorescence quantum yield is preferably less than 0.01. Plural host compounds may be used in combination. Using plural host compounds makes it possible to adjust charge transfer and to enhance efficiency of an organic EL element. Further, using plural phosphorescent compounds makes it possible to mix different emission light components, resulting in arbitrary emission color. Emission of white color can be obtained by adjusting kinds of phosphorescent compounds and dope amount and can be also applied to lighting equipment or a backlight.

As such a host compound, it is preferable to use a compound having a hole transporting ability and an electron transporting ability, as well as preventing elongation of an emission wavelength and having a high Tg (glass transition temperature). Examples of well-known host compounds include compounds described in Japanese Patent Application Laid-Open Nos. 2001-257076, 2002-308855, 2001-313179, 2002-319491, 2001-357977, 2002-334786, 2002-8860, 2002-334787, 2002-15871, 2002-334788, 2002-43056, 2002-334789, 2002-75645, 2002-338579, 2002-105445, 2002-343568, 2002-141173, 2002-352957, 2002-203683, 2002-363227, 2002-231453, 2003-3165, 2002-234888, 2003-27048, 2002-255934, 2002-260861, 2002-280183, 2002-299060, 2002-302516, 2002-305083, 2002-305084, 2002-308837, and the like.

Whenplural light emitting layers is incorporated, it is preferable that in view of ease of obtaining a uniform film state over the entire organic layer, 50% by weight or more of the host compounds in each layer be of the same compound. Further, it is preferable that the phosphorescence emission energy of the host compound be 2.9 eV or more so that it becomes more advantageous to efficiently suppress the energy transfer from the dopant to result in higher luminance. The phosphorescence emission energy means the peak energy of the 0-0 transition band of phosphorescence emission which is obtained by measuring photoluminescence of a 100 nm vapor deposition film of the host compound on a substrate.

In consideration of temporal deterioration (a decrease in luminance and degradation of film state) of the organic EL element and market needs of the organic EL element as a light source, it is preferable that the host compound have the phosphorescence emitting energy of 2. 9 eV or more, and Tg of 90°C or higher and preferably Tg of 100°C or higher. According to this, it is possible to satisfy both luminance and durability.

The phosphorescent compound (phosphorescent emission compound) is a compound in which emission from an excited triplet state thereof is observed and which emits phosphorescence at room temperature (25°C) and exhibits a phosphorescence quantum yield of 0.01 or more at 25°C. By using the phosphorescent compound together with the host compound described before, it is possible to obtain an organic EL element with higher efficiency of light emission.

A phosphorescence quantum yield of the phosphorescent compound according to the present invention is preferably 0.1 or more. The phosphorescence quantum yield can be measured by the method described on page 398 of Bunko (Spectroscopy) II of Dai 4 Han Jikken Kagaku Koza (4th Edition Experimental Chemistry Lectures) 7 (1992 Edition, Maruzen). The phosphorescence quantum yield in a solution can be measured using various solvents. However, it is only necessary for the phosphorescent compound used in the present invention to exhibit the above phosphorescence quantum yield using any of arbitrary solvents.

As the light emitting principle of the phosphorescent compound, two types of principle can be exemplified: one is an energy transfer type in which carriers undergo recombination on the host compounds to which carriers are transported to generate an excited state of the host compounds and by transferring the resulting energy to the phosphorescent compounds, whereby light emission is obtained from the phosphorescent compounds, and the other is a carrier trap type in which the phosphorescent compounds work as a carrier trap and carriers undergo recombination on the phosphorescent compounds, whereby it is possible to obtain light emission from the phosphorescent compounds. In either case, an essential condition is that energy of the excited state of the phosphorescent compounds is lower than that of the excited state of the host compounds.

The phosphorescent compound can be selected appropriately from well-known compounds used for the light emitting layer of the organic EL element for use. The phosphorescent compound is preferably a complex type compound containing a metal of Groups 8 to 10 on the periodic table, more preferably an iridium compound, an osmium compound, a platinum compound (platinum complex type compound) or a rare earth complex, and particularly preferably an iridium compound.

In the present invention, the maximum phosphorescence emission wavelength of the phosphorescent compound is not particularly limited. In principle, by selecting a central metal, a ligand, a substituent of a ligand, or the like,

it is possible to change emission wavelength to be obtained.

The color of light emitted by the organic EL element according to the present invention and compounds according to the present invention is specified as follows. In FIG. 4.16 on page 108 of "Shinpen Shikisai Kagaku Handbook (New Edition Color Science Handbook)" (edited by The Color Science Association of Japan, University of Tokyo Press, 1985), values measured by a spectroradiometric luminance meter CS-1000 (produced by Konica Minolta, Optics, Inc.) are applied to the CIE chromaticity coordinate, whereby the color is specified. In the CIE chromaticity coordinate, the term "white element" means that the term "white" means that the chromaticity is within a region of X = 0.33 ± 0.07, Y = 0.33 ± 0.07 according to CIE 1931 color coordinate system at 1,000 cd/m$^2$ when a front luminance at a viewing angle of 2 degrees is measured via the above method.

The sum of the film thicknesses of the light emitting layers is not particularly limited. However, in consideration of layer uniformity, a voltage necessary for light emission, or the like, the thickness is generally 2 nm to 5 μm, preferably 2 to 200 nm, and more preferably 10 to 20 nm. When the film thickness is 2 nm or less, there is an effect in which stability of light emission color not only against a voltage surface but also against driving electric current is improved, which is favorable. The film thickness of each light emitting layer is preferably 2 to 100 nm, and more preferably 2 to 20 nm. As for a film thickness relation among respective blue, green, and red light emitting layers, there is no particular limitation. However, among three light emitting layers, it is preferable that the thickness of the blue light emitting layer (in the case of plural layers, the sum thereof) be thickest.

The light emitting layer contains at least three or more layers each having a different emitting spectrum which shows a maximum emission wavelength in a range of 430 to 480 nm, 510 to 550 nm, and 600 to 640 nm, respectively. If the light emitting layer has three or more layers, there is no particular limitation. When the light emitting layer has more than four layers, it may have plural layers having the same emitting spectrum with each other. The layer is called a blue light emitting layer when the maximum emission wavelength is in a range of 430 to 480 nm, a layer is called a green light emitting layer when the maximum emission wavelength is in a range of 510 to 550 nm, and a layer is called a red light emitting layer when the maximum emission wavelength is in a range of 600 to 640 nm. Moreover, in the extent of maintaining the above-described maximum wavelength, plural luminescent compounds may be mixed to each light emitting layer. For example, a blue luminescent compound having a maximum wavelength of 430 to 480 nm and a green luminescent compound having a maximum wavelength of 510 to 550 nm may be used by mixing them.

(Hole Transport Layer)

The hole transport layer is formed by a hole transport material having a function of transporting the hole, and a hole injection layer and an electron blocking layer are included in the hole transport layer in a broad meaning. A single layer or plural layers of the hole transport layer can be provided.

The hole transport material is not particularly limited as long as it has either a hole injection function, a hole transport function, or an electron barrier function. An organic or inorganic material may be used. For example, examples of the hole transport material include a triazole derivative, an oxydiazole derivative, an imidazole derivative, a polyallyl alkane derivative, a pyrazoline derivative, a pyrazolone derivative, a phenylene diamine derivative, an aryl amine derivative, an amino-substituted chalcone derivative, an oxazole derivative, a styryl anthracene derivative, a fluorenone derivative, a hydrazone derivative, a stilbene derivative, a silazane derivative, an aniline copolymer, a conductive high molecular oligomer such as a thiophene oligomer, a porphyrin compound, an aromatic tertiary amine compound, and a styryl amine compound. Among them, an aromatic tertiary amine compound and a styryl amine compound are preferably used.

Examples of the aromatic tertiary amine compound and the styryl amine compound include N,N,N',N'-tetraphenyl-4,4'-diamino phenyl, N,N'-diphenyl-N,N'-bis(3-methyl phenyl)-[1,1'-biphenyl]-4,4'-diamine (TPD), 2,2-bis(4-di-p-tolylamino phenyl)propane, 1,1-bis(4-di-p-tolylamino phenyl)cyclohexane, N,N,N',N'-tetra-p-tolyl-4,4'-diamino biphenyl, 1,1-bis(4-di-p-tolylamino phenyl)-4-phenyl cyclohexane, bis(4-dimethylamino-2-methyl phenyl)phenylmethane, bis(4-di-p-tolylamino phenyl)phenylmethane, N,N'-diphenyl-N,N'-di(4-methoxyphenyl)-4,4'-diamino biphenyl, N,N,N',N'-tetraphenyl-4,4'-diaminodiphenyl ether, 4,4'-bis(diphenylamino)quadriphenyl, N,N,N-tri(p-tolyl)amine, 4-(di-p-tolylamino)-4'-[4-(di-p-tolylamino)styryl]stylb ene, 4-N,N-diphenylamino-(2-diphenylvinyl)benezene, 3-methoxy-4'-N,N-diphenylamino stilbenezene, N-phenyl carbazole, and those in which two condensed aromatic rings are contained in the molecule discribed in US Patent No. 5,061,569 as exemplified by 4,4'-bis[N-(1-naphthyl)-N-phenylamino]biphenyl (NPD), and 4,4',4"-tris[N-(3-methyl phenyl)-N-phenylamino]triphenyl amine (MTDATA) discribed in Japanese Patent Application Laid-Open No. 4-308688 in which a triphenyl amine unit is linked with three star burst types.

A high molecular material in which the above-described materials are introduced into a high molecular chain or the above-described materials are used as a principal chain of the high polymer may be used. Further, an inorganic compound of p-type-Si or p-type-SiC may also be used.

Further, a so-called p-type hole transport material described in Japanese Patent Application Laid-Open No. 11-251067 and Literature (Applied Physics Letters 80 (2002), p.139) by J. Huang et.al. can be also utilized.

The hole transport layer can be formed by forming the above-described material into a thin film according to a well-known method, for example, a vacuum vapor deposition method, a spin coating method, a casting method, and a printing method including an inkjet method, an LB method, or the like.

The film thickness of the hole transport layer is not particularly limited, but, generally, the film thickness thereof is 5 nm to 5 μm and preferably 5 to 200 nm.

The hole transport layer may be a single layer structure formed by one or two or more of the above-described materials.

(Electron Transport Layer)

An electron transport layer is formed by an electron transport material having a function of transporting an electron, and, in a broad meaning, an electron injection layer and a hole blocking layer are included in the electron transport layer. A single layer or plural layers of the electron transport layer may be provided.

The material to transport an electron is not particularly limited as long as it has a function of transferring an electron injected from a cathode to an emission layer, and a well-known compound may be used. Examples of the material to transport an electron include a nitro- substituted fluorine derivative, a diphenylquinone derivative, a thiopyrandioxide derivative, carbodiimide, a fluorenylidenemethane derivative, anthraquinonedimethane, an anthrone derivative, an oxydiazole derivative, a thiadiazole derivative, a quinoxaline derivative, and the like. Further, polymer materials, in which these materials are introduced in a polymer chain or these materials form the main chain of polymer, can be also used. Furthermore, a metal complex of a 8-quinolinol derivative such as tris(8-quinolinol)aluminum (Alq), tris(5,7-dichloro-8-quinolinol)aluminum, tris(5,7-dibromo-8-quinolinol)aluminum, tris(2-methyl-8-quinolinol)aluminum, tris(5-methyl-8-quinolinol)aluminum, and bis(8-quinolinol)zinc (Znq); and metal complexes in which a central metal of the metal complexes is substituted by In, Mg, Cu, Ca, Sn, Ga or Pb, may be used. In addition, metal-free or metal phthalocyanine, or those the terminal of which is substituted by an alkyl group and a sulfonic acid group, may be used. Further, an inorganic semiconductor such as an n-type-Si and an n-type-SiC, which may be the material of the hole injection layer, may be also used.

The electron transport layer can be formed by forming the above-described material into a thin film according to a well-known method, for example, a vacuum vapor deposition method, a spin coating method, a casting method, and a printing method including an inkj et method, an LB method, or the like.

The film thickness of the electron transport layer is not particularly limited, but, generally, the film thickness thereof is 5 nm to 5 μm and preferably 5 to 200 nm.

The electron transport layer may be a single layer structure formed by one or two or more of the above-described materials.

(Preparation Method of Organic EL Element)

The preparation method of an organic EL element will be described by exemplifying an organic EL element formed by anode/hole injection layer/hole transport layer/light emitting layer/electron transport layer/electron injection layer/cathode.

A thin film which is composed of a desired electrode substance, for example, an anode substance, is formed on the functional film by a method such as a deposition method, a sputtering method, or a plasma CVD method such that the film thickness is 1 μm or less, and preferably 10 to 200 nm, thereby preparing an anode.

Subsequently, a thin organic compound film composed of a hole injecting layer, a hole transport layer, a light emitting layer, an electron transport layer, and an electron injection layer, which are materials of the organic EL element is formed on the above film. Examples of the film formation method of the thin organic compound film include a vapor deposition method and a wet process (a spin coating method, a casting method, an inkjet method, and a printing method) and the like. In view of ease of formation of a homogenous film and reduced formation of pin holes, it is preferable to use a vacuum vapor deposition method, a spin coating method, an inkjet method, and a printing method. At this time, different film formation methods may be employed for each layer. When a deposition method is employed for film formation, although the deposition conditions vary depending on types of compounds to be used, generally, a boat heating temperature may be 50 to 450°C, a vacuum degree may be $10^{-6}$ to $10^{-2}$ Pa, a deposition rate may be 0.01 to 50 nm/sec, a substrate temperature may be -50 to 300°C, and a film thickness may be 0.1 nm to 5 μm, and preferably 5 to 200 nm.

After forming these layers, a thin layer composed of substances for a cathode is formed on the above layers by, for example, a method such as a vapor deposition method or a sputtering method such that the film thickness thereof is 1 μm or less, and preferably 50 to 200 nm, to provide a cathode, thereby preparing an organic EL element.

As for the preparation of the organic EL element, it is preferable to consistently produce portions from an anode, a hole injection layer to a cathode through one vacuuming operation. However, substances may be taken out in the

course of the producing process and then a different film formation method may be carried out. In this case, required is attention in which the process is carried out, for example, under a dried inert gas atmosphere. Moreover, by reversing the preparation order, it is possible to achieve preparation, in the order of a cathode, an electron injection layer, an electron transport layer, a light emitting layer, a hole transport layer, a hole injection layer, and an anode.

When a direct-current voltage is applied to the multicolor display device (organic EL panel) provided with the organic EL element as prepared above, application of voltages of, for example, 2 to 40 V, employing the anode as positive polarity and the cathode as negative polarity, makes it possible to observe light emission. Further, an alternating-current voltage may be applied. Incidentally, alternating-current waveform to be applied may be selected appropriately.

The external extraction efficiency of light emitted by the organic EL element according to the present invention is preferably 1% or more at room temperature, and more preferably 5% or more. Incidentally, the external extraction quantum efficiency (%) is calculated by the following formula.

[Mathematical Formula 3]

External extraction quantum efficiency (%) = the number of photons emitted by the organic EL element to the exterior/the number of electrons fed to organic EL element) × 100

Further, even by simultaneously employing a color hue improving filter such as a color filter, a color conversion filter which converts emitted light color from the organic EL element to multicolor by employing fluorescent materials may be simultaneously employed. When the color conversion filter is employed, it is preferable that $\lambda_{max}$ of light emitted by the organic EL element be 480 nm or less.

EXAMPLES

Hereinafter, the present invention will be described in detail with reference to Examples; however, the present invention is not limited thereto. Incidentally, the expression "part(s)" or "%" used in Examples indicates "part(s) by mass" or "% by mass", unless otherwise specified.

Example 1: Gas Barrier Film

<<Preparation of Substrate>>

<Film Base material>

PURE-ACE WR-S148 manufactured by Teij in Chemicals Ltd. (film thickness: 50 μm) formed by polycarbonate (PC) was prepared as a film base material having a function serving as a λ/4 phase difference plate.

<Formation of Smoothing layer>

The thermosetting inorganic-organic hybrid coat #2087 manufactured by Idemitsu Technofine Co., Ltd. was coated on one surface of the film base material prepared above by spin coating such that the dried film thickness was 900 nm, followed by drying at 80°C for 10 minutes and then aging under the environment of 23°C and 55%RH for three days to prepare a λ/4 phase difference plate attached with the smoothing layer.

When the obtained smoothing layer was measured according to the method specified in JIS B 0601, the surface roughness Ra was 3 nm and Rz was 20 nm. Incidentally, the surface roughness was measured using AFM (atomic force microscope) SPI3800N DFM manufactured by SII Nano Technology Inc. A measured range at one step was 80 μm × 80 μm, three measurements were carried out on different measurement spots, and the average of Ra values and ten-point average roughness Rz values obtained in the respective measurements was regarded as a measured value.

<<Preparation of Gas Barrier Film>>

<Preparation of Sample 1-1>

On the surface of the smoothing layer of the substrate produced above, a gas barrier layer formed by the plasma CVD was formed under the following conditions to have a film thickness of 15 nm, thereby producing Sample 1-1.

(Film Formation Conditions)

[Formation of First Barrier Layer 1]

The first barrier layer 1 (15 nm) of silicon oxide was formed by an atmospheric pressure plasma method using an atmospheric pressure plasma film production apparatus (an atmospheric pressure plasma CVD apparatus in roll-to-roll form, illustrated in Fig. 3 in Japanese Patent Application Laid-Open No. 2008-56967) under the following thin film formation conditions.

(Mixed Gas Compositions)

Discharge gas: Nitrogen gas 94.9% by volume
Thin film formation gas: Tetraethoxysilane 0.1% by volume
Additive gas: Oxygen gas 5.0% by volume
(Film Formation Conditions)

<First Electrode Side>

Type of power source: Haiden Laboratory 100 kHz (Continuous mode) PHF-6k
Frequency: 100 kHz
Output density: 10 $W/cm^2$
Electrode temperature: 120°C

<Second Electrode Side>

Type of power source: Pearl Kogyo Co., Ltd. , 13.56 MHz, CF-5000-13M
Frequency: 13.56 MHz
Output density: 10 $W/cm^2$
Electrode temperature: 90°C

<Substrate Temperature>

The substrate temperature was controlled to 40°C by adjusting the temperature of the back roll during the film formation to 40°C.

<Preparation of Sample 1-2>

On the surface of the smoothing layer of the substrate used in the production of Sample 1-1, a gas barrier layer was formed by performing conversion to polysilazane through the vacuum ultraviolet ray irradiation treatment according to the following method, thereby preparing Sample 1-2.

(Preparation of Polysilazane-Containing Coating Liquid)

A dibutyl ether solution containing 20% by mass of perhydropolysilazane (PHPS) as a non-catalyst (NN120-20 manufactured by AZ Electronic Materials) and a dibutyl ether solution containing 1% by mass of N,N,N',N'-tetramethyl-1,6-diaminohexane as an amine catalyst and 19% by mass of perhydropolysilazane (NAX120-20 manufactured by AZ Electronic Materials) were mixed at a ratio of 4 : 1 (mass ratio), and the content of the amine catalyst was adjusted to 1% by mass with respect to the solid content of the coating liquid. Further, the mixed solution was appropriately diluted with dibutyl ether according to a setting film thickness. Accordingly, the polysilazane-containing coating liquid was prepared.

(Formation of Polysilazane-Containing Coating Film)

The polysilazane-containing coating liquid prepared above was coated using a spin coater under the condition such that the film thickness after drying was the setting film thickness, thereby forming a polysilazane-containing coating film. The drying condition was 100°C for two minutes.

(Vacuum Ultraviolet Ray Irradiation Treatment)

After the polysilazane-containing coating film was formed as described above, a gas barrier layer was formed by performing the vacuum ultraviolet ray irradiation treatment according to the following method. The details of each treatment condition are described in Table 1 below.

<Vacuum Ultraviolet Ray Irradiation Condition and Irradiation Energy Measurement>

The vacuum ultraviolet ray irradiation was carried out using an apparatus illustrated in the schematic cross-sectional view of Fig. 2.

In Fig. 2, Reference Numeral 11 denotes an apparatus chamber and the apparatus chamber 11 can maintain the concentration of oxygen to be a predetermined concentration in such a manner that water vapor is substantially removed from the inside of the chamber by supplying nitrogen and oxygen to the inside from a gas supply port (not illustrated) at an appropriate amount and discharging them from a gas discharge port (not illustrated). Reference Numeral 12 denotes a Xe excimer lamp which irradiates a vacuum ultraviolet ray of 172 nm and has a double-tubular structure, and Reference Numeral 13 denotes a holder of the excimer lamp, functioning also as an external electrode. Reference Numeral 14 denotes a sample stage. The sample stage 14 can move back and forth horizontally at a predetermined speed in the apparatus chamber 11 by a moving means (not illustrated). Further, the sample stage 14 canbemaintained at a predetermined temperature by a heating means (not illustrated). Reference Numeral 15 denotes a sample with a polysilazane-containing coating film formed thereon. The height of the sample stage 14 is adjusted such that, when the sample stage 14 moves horizontally, the shortest distance between the coating layer surface of the sample and the tubular surface of the excimer lamp is 3 mm. Reference Number 16 denotes a light shielding plate and the light shielding plate 16 prevents irradiation of vacuum ultraviolet light on the coating film of the sample during aging of the Xe excimer lamp 12.

The energy irradiated on the coating film surface of the sample in the vacuum ultraviolet ray irradiation process was measured by using a ultraviolet integrated actinometer C8026/H8025 UV POWER METER manufactured by Hamamatsu Photonics K.K. and a sensor head of 172 nm. For the measurement, the sensor head was set at the center of the sample stage 14 such that the shortest distance between the tubular surface of the Xe excimer lamp and the measurement surface of the sensor head is 3 mm. Further, nitrogen and oxygen were supplied such that the atmosphere inside the apparatus chamber 11 has the same oxygen concentration as the vacuum ultraviolet ray irradiation process and the sample stage 14 was moved at the rate of 0.5 m/min to perform the measurement. Before the measurement, in order to stabilize the illuminance of the Xe excimer lamp 12, aging time of 10 minutes was allowed after lighting the Xe excimer lamp. After that, by moving the sample stage 14, the measurement was initiated.

Based on the irradiation energy obtained from the above measurement, adjustment was made to have the irradiation energy described in Table 1 by adjusting the movement rate of the sample stage 14. Incidentally, for the vacuum ultraviolet ray irradiation, it was performed after aging time of 10 minutes, similarly to the measurement of irradiation energy.

<Preparation of Sample 1-3>

A gas barrier layer having a configurationof five layers in total, which was formed by alternately laminating three inorganic gas barrier layers and two organic intermediate layers, was formed on the surface of the smoothing layer of the substrate used in the preparation of Sample 1-1 by the same method as described in US Patent No. RE40531, thereby preparing Sample 1-3.

<Preparation of Sample 1-4>

(Formation of Gas Barrier Unit)

First Barrier Layer

A gas barrier layer (first barrier layer) was formed on the surface of the smoothing layer of the substrate produced

above by plasma CVD in the same manner as in Sample 1-1.

Second Barrier Layer

A polysilazane-containing coating film was formed on the surface of the gas barrier layer (first barrier layer) formed above in the same manner as in Sample 1-2. Thereafter, the coating film was converted by performing the vacuum ultraviolet ray irradiation treatment to form a gas barrier layer (second barrier layer), thereby obtaining Sample 1-4.

<<Evaluation of Water Vapor Barrier Property>>

For each of Samples 1-1 to 1-4 prepared above, samples subjected to a bending treatment and not subjected to the bending treatment were prepared and water vapor barrier property was evaluated by measuring a water vapor transmission rate (WVTR) using the following method. Incidentally, as for the bending treatment, the bending treatment was performed on each of the inner side and the outer side of the gas barrier unit at a curvature of 50 mmϕ and 100 times, that is, the bending treatment was performed 200 times in total.

(Apparatus for Preparing Sample for Evaluation of Water vapor Barrier Property)

Vapor deposition apparatus: Vacuum deposition apparatus JEE-400, manufactured by JEOL Ltd.
Constant temperature-constant humidity oven: Yamato Humidic Chamber IG47M

(Raw Material)

Metal corroded by reaction with water: Calcium (granular)
Water vapor impermeable metal: Aluminum (ϕ3 to 5 mm, granular)
(Preparation of Sample for Evaluation of Water vapor Barrier Property)
Metal calcium was evaporated with a size of 12 mm × 12 mm through a mask on the surfaces of the gas barrier films (gas barrier layers) of the prepared gas barrier films using a vacuum deposition apparatus (vacuum deposition apparatus JEE-400, manufactured by JEOL Ltd.). In this case, the evaporated film thickness was set to be 80 nm.

After that, the mask was removed while the vacuum state was maintained, and aluminum was evaporated and temporarily sealed on the entire surface of one side of the sheet. Subsequently, the vacuum state was released and the sample was promptly shifted to the dried nitrogen atmosphere, quartz glass with a thickness of 0.2 mm was fixed to the aluminum-evaporated surface through a UV curable resin for sealing (manufactured by Nagase ChemteX Corporation), and the resin was cured and attached to be really sealed by irradiating with ultraviolet light to prepare a sample for evaluation of a water vapor barrier property.

The obtained samples were stored under a high temperature and high humidity of 60°C and 90%R and aspects where metal calcium proceeds to being corroded according to storage times were observed. The observation was performed for each of an hour until the storage time becomes 6 hours, for each of 3 hours from that time to 24 hours, for each of 6 hours from that time to 48 hours, and for each of 12 hours from that time, and an area with the corroded metal calcium with respect to a metal calcium-deposited area of 12 mm × 12 mm was calculated by % expression. The time at which the area with the corroded metal calcium becomes 1% was obtained by interpolation of a straight line from the observation result. Then, a water vapor transmission rate (WVTR) of each gas barrier film was calculated from the relation among the metal calcium-deposited area, an amount of water vapor, which causes the metal calcium to be corroded, of 1% area, and a time required for the corrosion. The results are shown in Table 1 described below.

As for the Sample 1-4 prepared by forming the second barrier layer in addition to the first gas barrier layer, a value n, which was obtained when it is assumed that a decrease rate of the water vapor transmission rate by the lamination of the second barrier layer to Sample 1-1 formed with the first barrier layer only is set as 1/n, was obtained and then, similarly, the obtained value n is shown in Table 1 described below.

[Table 1]

| Sample No. | Base material | Base material | First barrier layer | | | Intermediate layer 1 | | | Second barrier layer | | | Intermediate layer 2 | | | Third barrier layer | | | WVTR before bending | WVTR after bending | Evaluation |
|---|---|---|---|---|---|---|---|---|---|---|---|---|---|---|---|---|---|---|---|---|
| | | | Production method | Composition | Film thickness | Production method | Composition | Film thickness | Production method | Composition | Film thickness | Production method | Composition | Film thickness | Production method | Composition | Film thickness | | | |
| 1-1 Comparative Example | λ/4-PC *1 | Thermosetting inorganic-organic hybrid coat*2 | PECVD | SiOx | 100 nm | - | - | - | - | - | - | - | - | - | - | - | - | $2\times10^{-3}$ | $2\times10^{-3}$ | × |
| 1-2 Comparative Example | | | PHPS application Excimer light $3 J/cm^2$ | SiOxNy | 300 nm | - | - | - | - | - | - | - | - | - | - | - | - | $2\times10^{-3}$ | $2\times10^{-3}$ | × |
| 1-3 Comparative Example | | | PECVD | SiOx | 50 nm | Flash deposition UV curable polymerization | Acrylic | 700 nm | PECVD | SiOx | 50 nm | Flash deposition UV curable polymerization | Acrylic | 700 nm | PECVD | SiOx | 50 nm | $1\times10^{-3}$ | $3\times10^{3}$ | × |
| 1-4 Present Invention | | | PECVD | SiOx | 100 nm | - | - | - | PHPS application Excimer light $3 J/cm^2$ | SiOxNy | 300 nm | - | - | - | - | - | - | $8\times10^{-6}$ n=250 | $8\times10^{-6}$ n=250 | ○ |

*1 PURE-ACE WR-S148 (50 μm) manufactured by Teijin Chemicals Ltd.
*2 Inorganic-organic hybrid coat #2087 manufactured by Idemitsu Technofine Co., Ltd.: hybrid of modified polyalkylsiloxane and acrylic ester copolymer

As presented in Table 1, it was found that the gas barrier film of the present invention has very high water vapor barrier properties. Moreover, it was found that by laminating the second barrier layer on the first barrier layer, the water vapor transmission rate (WVTR) decreases greatly and further the water vapor barrier property does not deteriorate even when the bending treatment is performed.

Example 2: Organic EL Element

«Preparation of Organic Thin Film Electronic Device»

Bottom-emission type organic EL elements 2-1 to 2-4 were prepared using Samples 1-1 to 1-4 prepared in Example 1 described above as a sealing film by the following method.

<Preparation of Organic EL Element>

(Formation of First Electrode Layer)

An ITO (indium tin oxide) film with a thickness of 150 nm was formed on the gas barrier unit (gas barrier layer) of each of Samples 1-1 to 1-4 of the gas barrier films by a sputtering method, and patterning was carried out by a photolithography method to form a first electrode layer. Meanwhile, the pattern was made to have a light emission area of 50 $mm^2$.

(Formation of Hole Transport Layer)

A coating liquid for forming a hole transport layer to be described below was coated on the first electrode layer of each sample having the first electrode layer formed thereon using an extrusion coater, and then a hole transport layer was formed by drying. The coating liquid for forming a hole transport layer was coated such that the thickness thereof after drying is 50 nm.

Before applying the coating liquid for forming a hole transport layer, a treatment for modifying a cleaned surface of the sample was performed at an irradiation intensity of 15 $mW/cm^2$ and a distance of 10 nm by using a low pressure mercury lamp with a wavelength of 184.9 nm. The antistatic treatment was performed by using a neutralizer having weak X ray.

Coating Condition

The coating process was performed under the air environment of 25°C and 50%RH.

Preparation of Coating Liquid for Forming Hole Transport Layer

A solution obtained by diluting polyethylene dioxythiophene polystyrene sulfonate (PEDOT/PSS, Bytron P AI 4083 produced by Bayer) to 65% with pure water and 5% with methanol was prepared as a coating liquid for forming a hole transport layer.

Condition for Drying and Heating Treatment

After applying the coating liquid for forming a hole transport layer, the solvent was removed at a temperature of 100°C with air from a height of 100 mm, a discharge air speed of 1 m/s, and a width air speed distribution of 5% toward the formed film surface. Subsequently, by using an apparatus for heating treatment, a heating treatment in a heat-transfer mode of being heated from the rear surface was performed at 150°C to form a hole transport layer.

(Formation of Light Emitting Layer)

Subsequently, on the hole transport layer of each sample having a hole transport layer formed thereon, a coating liquid for forming a white light emitting layer described below was coated by using an extrusion coater, and an light emitting layer was formed by drying. The coating liquid for forming a white light emitting layer was coated such that the thickness after drying is 40 nm.

Coating Liquid for Forming White Light Emitting Layer

1.0 g of the host material H-A, 100 mg of the dopant material D-A, 0.2 mg of the dopant material D-B, and 0.2 mg of the dopant material D-C were dissolved in 100 g of toluene to prepare the solution as a coating liquid for forming

a white light emitting layer.

[Chem. 6]

H-A

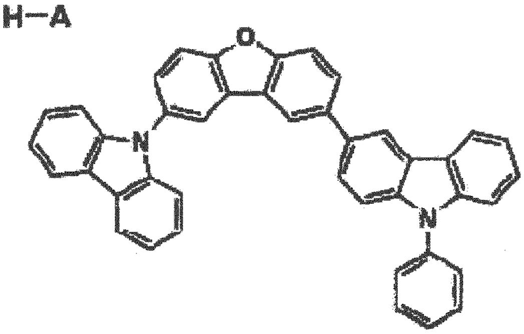

D-A

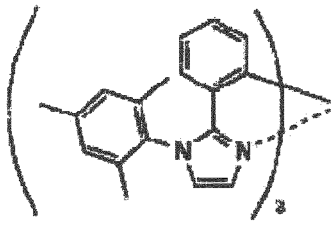

D-B

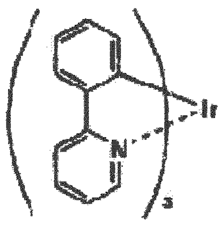

D-C

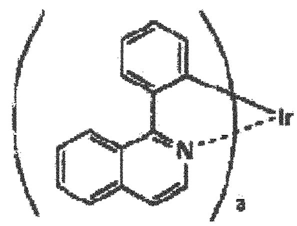

Coating Condition

The coating process was performed under the atmosphere with a nitrogen gas concentration of 99% or more, and at a temperature of 25°C and a coating speed of 1 m/min.

Condition for Drying and Heating Treatment

After applying the coating liquid for forming a white light emitting layer, the solvent was removed at a temperature of 60°C with air from a height of 100 mm, a discharge air speed of 1 m/s, and a width air speed distribution of 5% toward the formed film surface. Subsequently, a light emitting layer was formed by performing a heating treatment at a temperature of 130°C.

(Formation of Electron Transport Layer)

Subsequently, after the coating liquid for forming an electron transport layer to be described below was coated on the light emitting layer of each sample having the light emitting layer formed thereon, an electron transport layer was formed by drying the coating liquid for forming an electron transport layer. The coating liquid for forming an electron transport layer was coated such that the thickness after drying is 30 nm.

Coating Condition

The coating process was performed under the atmosphere with a nitrogen gas concentration of 99% or more, and at a temperature of 25°C and a coating speed of 1 m/min of the coating liquid for forming an electron transport layer.

Preparation of Coating Liquid for Forming Electron Transport Layer

As for the electron transport layer, the E-A was dissolved in 2,2,3,3-tetrafluoro-1-propanol to obtain a 0.5% by mass solution, which was then used as a coating liquid for forming an electron transport layer.

[Chem. 7]

E-A

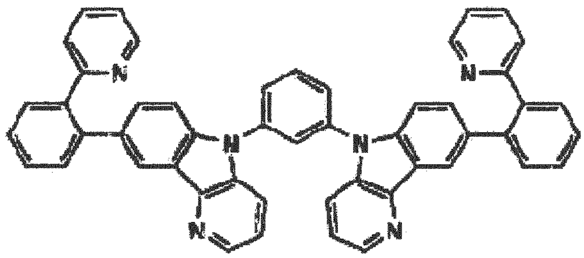

Condition for Drying and Heating Treatment

After applying the coating liquid for forming an electron transport layer, the solvent was removed at a temperature of 60°C with air from a height of 100 mm, a discharge air speed of 1 m/s, and a width air speed distribution of 5% toward the formed film surface. Subsequently, an electron transport layer was formed by performing a heating treatment at a temperature of 200°C in a heating treatment part.

(Formation of Electron Injection Layer)

Subsequently, an electron injection layer was formed on the electron transport layer of each sample having the electron transport layer formed thereon. First, the substrate was added into a chamber under reduced pressure, and the pressure was reduced to $5 \times 10^{-4}$ Pa. By heating cesium fluoride which has been prepared in advance in a tantalum deposition boat within a vacuum chamber, an electron injection layer having a thickness of 3 nm was formed.

(Formation of Second Electrode Layer)

Subsequently, on the electron injection layer of each sample having the electron injection layer formed thereon, except a portion that becomes an extraction electrode on the first electrode layer, a mask pattern film was formed to have a light emission area of 50 $mm^2$ by using aluminum as a material for forming a second electrode layer under vacuum of $5 \times 10^{-4}$ Pa and a vapor deposition method to have anextractionelectrode, andasaresult, the second electrode layer having a thickness of 100 nm was formed.

(Cutting)

Each sample formed up to the second electrode layer was transferred again to the nitrogen atmosphere, and cut into a predetermined size by using ultraviolet laser to prepare an organic EL element.

(Attachment of Electrode Lead)

To the prepared organic EL element, a flexible print substrate (base film: polyimide 12.5 μm, pressed copper foil 18 μm, cover layer: polyimide 12.5 μm, surface treatment: NiAuplating) was attached by using an anisotropic conductive film DP3232S9 manufactured by Sony Chemical & Information Device Corporation.

Compression condition: compression was performed for 10 seconds at a temperature of 170°C (ACF temperature of 140°C measured by using a separate thermocouple) and a pressure of 2 MPa.

(Sealing)

The organic EL element attached with an electrode lead (flexible print substrate) was attached with a sealing member by using a commercially available roll lamination apparatus to prepare Sample 2-1 to 2-4 of organic EL elements. Meanwhile, as a sealing member, a 30-μm thick aluminum foil (manufactured by TOYO ALUMINIUM K.K.) laminated with a polyethylene terephthalate (PET) film (12-μm thick) by using an adhesive for dry lamination (two-liquid reaction type urethane-based adhesive) was used (thickness of adhesive layer: 1.5 μm). At this time, as for the attachment of the sealing member, a thermosetting adhesive was uniformly coated along the adhesive surface (glossy surface) of an aluminum foil to have a thickness of 20 μm by using a dispenser. Further, as the thermosetting adhesive, the following epoxy-based adhesive was used.

Bisphenol A diglycidyl ether (DGEBA)
Dicyandiamide (DICY)
Epoxy adduct-based curing promoter

After that, the sealed substrate was closely attached and placed such that the connection portion between the extraction electrode and the electrode lead is covered. Then, the sealed base material was tightly sealed by using a compression roll with a compression condition including a compression roll temperature of 120°C, a pressure of 0.5 MPa, and an apparatus speed of 0.3 m/min.

<<Evaluation of Organic EL Element>>

Samples 2-1 to 2-4 of the organic EL elements prepared above were subjected to durability evaluation according to the method described below.

[Durability Evaluation]

(Accelerated Deterioration Treatment)

Each Sample of the organic EL element prepared above was subjected to an accelerated deterioration treatment for 1000 hours under the environment of 60°C and 90%RH. Thereafter, together with an organic EL element not treated with an accelerated deterioration treatment, durability was evaluated by performing an evaluation of dark spots.

(Evaluation of Dark Spots)

Each sample of the organic EL elements after the accelerated deterioration treatment and the organic EL element not treated with the accelerated deterioration treatment was applied with an electric current of 1 $mA/cm^2$. After continuous light emission for 24 hours, a part of the panel was enlarged by using 100x microscope (MS-804 manufactured by MORITEX CORPORATION, lens: MP-ZE25-200), and a photographic image was taken. After cutting the photographed image to a 2-mm square, the ratio of an area having dark spots was obtained and the ratio of resistance to element deterioration was calculated according to the following formula. The durability was then evaluated according to the following criteria. When the evaluated rank is ⊙ or ○, it was determined, as apracticallypreferable property.

Resistance to element deterioration = (Area of dark spots occurred in an element not treated with accelerated deterioration treatment/Area of dark spots occurred in an element treated with accelerated deterioration treatment) × 100 (%)

⊙: Resistance to element deterioration is 90% or more.
○: Resistance to element deterioration is 60% or more but less than 90%.
Δ: Resistance to element deterioration is 20% or more but less than 60%.
X: Resistance to element deterioration is less than 20%.

The results obtained from above are shown in Table 2 below.

Further, Samples 2-1 to 2-4 of the organic EL elements prepared above were subjected to internal reflectance evaluation according to the method described below.

<Evaluation of Internal Reflectance>

At the display surface side of each sample of the organic EL element prepared above, prepared was an element in which absorption-type linear polarizing plates are bonded and laminated in an arrangement manner that they have a circularly polarizing function.

Subsequently, light reflectance of each sample of the obtained organic EL element attached with a polarizing light plate was measured and the internal reflectance was calculated by subtracting the surface reflectance (4.5%) from the measured value of the obtained reflectance.

The results obtained from above are shown in Table 2 below.

[Table 2]

| Sample No. | Gas barrier film No. | Evaluation of resistance to element deterioration | Internal reflectance (%) |
|---|---|---|---|
| 2-1 | 1-1 Comparative Example | × | 2.1 |

(continued)

| Sample No. | Gas barrier film No. | Evaluation of resistance to element deterioration | Internal reflectance (%) |
|---|---|---|---|
| 2-2 | 1-2 Comparative Example | × | 2.0 |
| 2-3 | 1-3 Comparative Example | Δ | 1.5 |
| 2-4 | 1-4 Present invention | ⊙ | 1.2 |

As clearly seen from the results shown in Table 2, it is found that the gas barrier film of the present invention has an extremely high gas barrier property so that the gas barrier film can be used as a sealing film of the organic EL element. Moreover, in addition to the above, it is found that the gas barrier film of the present invention can also effectively reduce internal reflection in a display device such as an OLED display device.

The present application is based on Japanese Patent Application No. 2012-100245 filed on April 25, 2012, and its disclosure is incorporated herein by reference in its entirety.

## REFERENCE SIGNS LIST

1 FILM BASE MATERIAL
2 SMOOTHING LAYER
3 FIRST BARRIER LAYER
4 SECOND BARRIER LAYER
5 LINEAR POLARIZING PLATE (POLARIZER)
11 APPARATUS CHAMBER
12 Xe EXCIMER LAMP
13 HOLDER OF EXAMINER LAMP, FUNCTIONING ALSO AS EXTERNAL ELECTRODE
14 SAMPLE STAGE
15 SAMPLE WITH POLYSILAZANE-CONTAINING COATING FILM FORMED THEREON
16 LIGHT SHIELDING PLATE

## Claims

**1.** A gas barrier film comprising:

a film base material having optical anisotropy; and
a gas barrier unit disposed on at least one surface of the film base material,
wherein the gas barrier unit includes, from the side of the film base material, a first barrier layer containing an inorganic material and a second barrier layer obtained by performing a conversion treatment to a coating film formed by applying polysilazane.

**2.** The gas barrier film according to claim 1, wherein the film base material is a λ/4 phase difference plate.

**3.** The gas barrier film according to claim 1 or 2, wherein the conversion treatment is a treatment of irradiation with a vacuum ultraviolet ray.

**4.** The gas barrier film according to any one of claims 1 to 3, wherein a constituent material of the film base material includes one or two or more kinds selected from the group consisting of polycarbonate, a cycloolefin polymer, a cycloolefin copolymer, and a cellulose derivative.

**5.** The gas barrier film according to claim 4, wherein the constituent material of the film base material includes polycarbonate, the film further comprising a smoothing layer having no optical anisotropy and disposed between the film base material and the first barrier layer.

**6.** The gas barrier film according to any one of claims 1 to 5, wherein a linear polarizing plate is further disposed at the side opposite to the gas barrier unit of the film base material.

**7.** A substrate for an electronic device comprising:

the gas barrier film according to claim 6; and
a transparent electrode disposed at the side of the gas barrier unit constituting the gas barrier film, which is opposite to the film base material.

**8.** An electronic device using the gas barrier film according to any one of claims 1 to 6 or the substrate for an electronic device according to claim 7.

FIG. 1

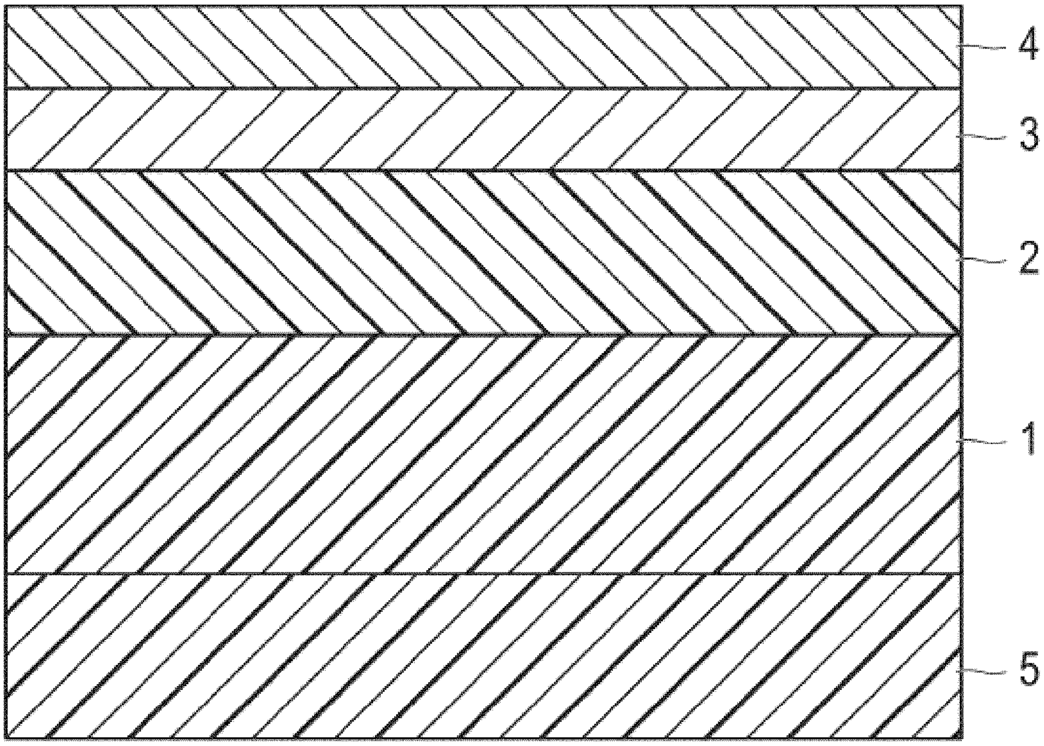

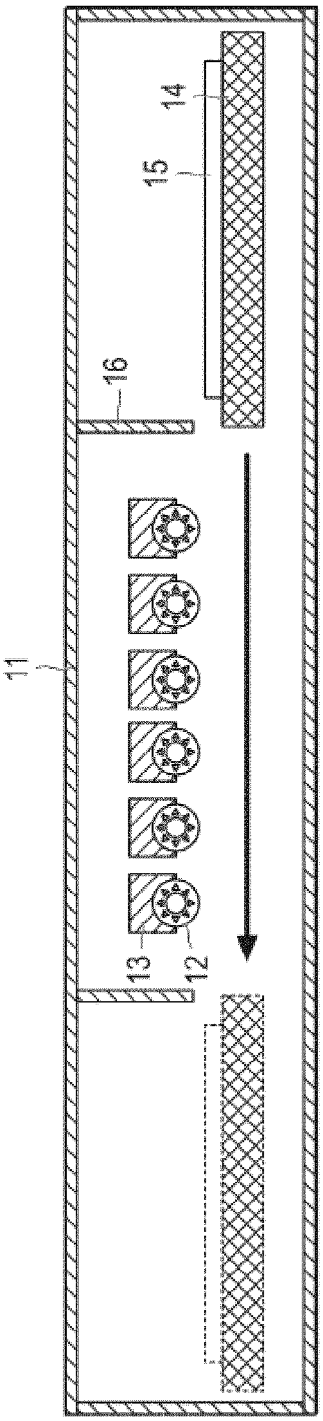


FIG. 2

**INTERNATIONAL SEARCH REPORT**

International application No.
PCT/JP2013/062103

A. CLASSIFICATION OF SUBJECT MATTER
*B32B9/00*(2006.01)i, *B05D7/04*(2006.01)i, *B05D7/24*(2006.01)i, *C08J7/04*(2006.01)i, *H01L51/50*(2006.01)i, *H05B33/04*(2006.01)i

According to International Patent Classification (IPC) or to both national classification and IPC

B. FIELDS SEARCHED

Minimum documentation searched (classification system followed by classification symbols)
B32B9/00, B05D7/04, B05D7/24, C08J7/04, H01L51/50, H05B33/04

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2013 |
| Kokai Jitsuyo Shinan Koho | 1971-2013 | Toroku Jitsuyo Shinan Koho | 1994-2013 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2003-118030 A (Asahi Glass Co., Ltd.), 23 April 2003 (23.04.2003), claims; paragraphs [0001], [0011] to [0023], [0044], [0051], [0055], [0075]; examples; fig. 1 to 2 (Family: none) | 1-4,7-8<br>1-8 |
| X<br>Y | JP 2003-327718 A (Dainippon Printing Co., Ltd.), 19 November 2003 (19.11.2003), claims; paragraphs [0001], [0014], [0020] to [0022], [0025], [0029], [0032] to [0034], [0040] to [0042], [0050]; examples; fig. 1 to 2 & US 2004/0018364 A1 | 1-2,4,8<br>1-8 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 19 July, 2013 (19.07.13) | 30 July, 2013 (30.07.13) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2013/062103

C (Continuation). DOCUMENTS CONSIDERED TO BE RELEVANT

| Category* | Citation of document, with indication, where appropriate, of the relevant passages | Relevant to claim No. |
|---|---|---|
| X<br>Y | JP 8-281861 A (Mitsui Toatsu Chemicals, Inc.), 29 October 1996 (29.10.1996), claims; paragraphs [0009], [0018]; example 6; fig. 1 to 3 (Family: none) | 1,4,8<br>1-8 |
| Y | JP 2008-536711 A (Alcan Technology & Management Ltd.), 11 September 2008 (11.09.2008), claims; paragraphs [0003], [0007]; examples & US 2009/0029056 A1 & EP 1888812 A1 & WO 2006/108503 A1 & CA 2603736 A & AU 2006233551 A & MX 2007011281 A | 1-8 |
| Y | JP 9-70917 A (Oike & Co., Ltd.), 18 March 1997 (18.03.1997), claims; paragraphs [0001], [0010] to [0030]; examples (Family: none) | 1-8 |
| Y | JP 11-151774 A (Dainippon Printing Co., Ltd.), 08 June 1999 (08.06.1999), claims; paragraphs [0001], [0008] to [0010]; examples; fig. 1 (Family: none) | 1-8 |
| Y | JP 2012-599 A (Konica Minolta Holdings, Inc.), 05 January 2012 (05.01.2012), claims; paragraphs [0001], [0057] to [0059], [0079], [0111], [0140]; examples (Family: none) | 1-8 |
| Y | JP 2011-156752 A (Konica Minolta Holdings, Inc.), 18 August 2011 (18.08.2011), claims; paragraphs [0001], [0097]; examples (Family: none) | 1-8 |
| Y | JP 2012-20516 A (Fujifilm Corp.), 02 February 2012 (02.02.2012), paragraphs [0024] to [0025] (Family: none) | 1-8 |
| A | JP 2009-226707 A (TDK Corp.), 08 October 2009 (08.10.2009), claims; paragraphs [0018] to [0026] (Family: none) | 1-8 |
| A | JP 2010-208029 A (Toppan Printing Co., Ltd.), 24 September 2010 (24.09.2010), claims; paragraph [0020] (Family: none) | 5 |

Form PCT/ISA/210 (continuation of second sheet) (July 2009)

**INTERNATIONAL SEARCH REPORT**

International application No.
PCT/JP2013/062103

C (Continuation). DOCUMENTS CONSIDERED TO BE RELEVANT

| Category* | Citation of document, with indication, where appropriate, of the relevant passages | Relevant to claim No. |
|---|---|---|
| A | JP 2001-301081 A (Sumitomo Chemical Co., Ltd.), 30 October 2001 (30.10.2001), claims (Family: none) | 1-2 |
| A | JP 10-282336 A (Kaneka Corp.), 23 October 1998 (23.10.1998), claims (Family: none) | 1-2,7 |
| P,A | JP 2012-106421 A (Konica Minolta Holdings, Inc.), 07 June 2012 (07.06.2012), claims; examples (Family: none) | 1-8 |
| P,A | JP 2012-131194 A (Konica Minolta Holdings, Inc.), 12 July 2012 (12.07.2012), claims; examples (Family: none) | 1-8 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2007012392 A
- JP 2009255040 A
- US RE40531 E
- JP 2003195271 A
- JP 2003347042 A
- JP 2004535514 PCT
- WO 2004105149 A
- JP 5238827 A
- JP 6122852 A
- JP 6240208 A
- JP 6299118 A
- JP 6306329 A
- JP 7196986 A
- US 6503634 B
- JP 2007017948 A
- JP 2003248123 A
- JP 2003342322 A
- JP 2000137116 A
- JP 9045479 A
- JP 9260062 A
- JP 8288069 A
- JP 6325871 A
- JP 9017574 A
- JP 10074586 A
- WO 9013148 A
- JP 2001257076 A
- JP 2002308855 A
- JP 2001313179 A
- JP 2002319491 A
- JP 2001357977 A
- JP 2002334786 A
- JP 2002008860 A
- JP 2002334787 A
- JP 2002015871 A
- JP 2002334788 A
- JP 2002043056 A
- JP 2002334789 A
- JP 2002075645 A
- JP 2002338579 A
- JP 2002105445 A
- JP 2002343568 A
- JP 2002141173 A
- JP 2002352957 A
- JP 2002203683 A
- JP 2002363227 A
- JP 2002231453 A
- JP 2003003165 A
- JP 2002234888 A
- JP 2003027048 A
- JP 2002255934 A
- JP 2002260861 A
- JP 2002280183 A
- JP 2002299060 A
- JP 2002302516 A
- JP 2002305083 A
- JP 2002305084 A
- JP 2002308837 A
- US 5061569 A
- JP 4308688 A
- JP 11251067 A
- JP 2008056967 A
- JP 2012100245 A


### Non-patent literature cited in the description


- Organic ELElements and Industrialization Front there. Electrode Materials. N. T. S Corp, 30 November 1998, vol. 2, 123-166
- *Chemistry of Synthetic Dyes,* 1971, 628-637, 640
- *Appl. Phys. Lett.,* 1991, vol. 58 (18), 1982
- II of Dai 4 Han Jikken Kagaku Koza. Bunko. Maruzen, 1992, 398
- Shinpen Shikisai Kagaku Handbook. University of Tokyo Press, 1985, 108
- **J. HUANG.** *Applied Physics Letters,* 2002, vol. 80, 139